# EUROPEAN PATENT APPLICATION

(11) **EP 4 848 749 A1**
(43) Date of publication of application: **02.12.2026**
(21) Application number: 26180727.5
(22) Date of filing: 22.05.2026
(51) Int. Cl.: H04N 25/78, H03M 1/66, H04N 25/42, H04N 25/709

(54) **PHOTOELECTRIC CONVERSION APPARATUS, PHOTOELECTRIC CONVERSION SYSTEM, MOVING OBJECT, AND CONTROL METHOD**

(30) Priority: 29.05.2025 JP 2025089709
(71) Applicant: Canon Kabushiki Kaisha, Tokyo 146-8501 (JP)
(72) Inventor: ISOBE, Hirokazu, Tokyo, 146-8501 (JP); KOBAYASHI, Hideo, Tokyo, 146-8501 (JP); TANIGUCHI, Hiroaki, Tokyo, 146-8501 (JP); NIWA, Masashi, Tokyo, 146-8501 (JP)
(74) Representative: Canon Europe Limited

(57) **Abstract**

A photoelectric conversion apparatus includes a pixel, a first output circuit configured to output a first signal having an amplitude value selected from a first number of amplitude values based on a signal output from the pixel, the first number being two or more, a second output circuit configured to output a second signal having an amplitude value selected from a second number of amplitude values based on a signal output from the pixel, the second number being different from the first number, and a control circuit configured to control the first output circuit and the second output circuit, wherein the control circuit is configured to control the first output circuit and the second output circuit to be in a first mode, and wherein, in the first mode, the first output circuit is in a power-saving state during a period in which the second output circuit is in an operation state.

## Description

### Technical Field

The present disclosure relates to a photoelectric conversion apparatus, a photoelectric conversion system, a moving object, and a control method.

### BACKGROUND

Japanese Patent Laid-Open No. 2023-061885 describes a photoelectric conversion apparatus including a pixel array, a signal processing portion, and a data output unit. The signal processing portion performs signal processing, including digitization (analog-to-digital (AD) conversion), on a signal read from the pixel array. The data output unit is configured to output an amplitude-modulated signal having an amplitude value selected from three or more amplitude values based on a signal output from the signal processing portion.

Since the amplitude value is selected from three or more amplitude values, e.g., four amplitude values, the output unit described in Japanese Patent Laid-Open No. 2023-061885 can transmit more information than an output unit for 1-bit transmission.

Japanese Patent Laid-Open No. 2023-061885 describes a layout of an output circuit configured to output an amplitude-modulated signal having an amplitude value selected from three or more amplitude values. However, details regarding control of a plurality of output circuits configured to output amplitude-modulated signals having amplitude values selected from different amplitude values are not described. For example, details regarding control of an output circuit configured to output an amplitude-modulated signal having an amplitude value selected from three or more amplitude values and an output circuit configured to output an amplitude-modulated signal having an amplitude value selected from two amplitude values are not described.

### SUMMARY

Power consumption may increase depending on a control method. One object of the present disclosure is to provide a photoelectric conversion apparatus which reduces power consumption.

The present disclosure in its first aspect provides a photoelectric conversion apparatus as specified in claim 1. Optional features are specified in claims 2 to 11.

The present disclosure in its second aspect provides a photoelectric conversion system as specified in claim 12. Optional features are specified in claim 13.

The present disclosure in its third aspect provides a moving object as specified in claim 14.

The present disclosure in its fourth aspect provides a control method as specified in claim 15.

Features of the present disclosure will become apparent from the following description of embodiments with reference to the attached drawings. The following description of embodiments is described by way of example.

### BRIEF DESCRIPTION OF THE DRAWINGS

Fig. 1 is a diagram illustrating an example of a configuration of a photoelectric conversion apparatus according to a first embodiment.
Fig. 2 is a diagram illustrating an example of a configuration of a pixel of a photoelectric conversion apparatus.
Fig. 3 is a diagram illustrating an example of a configuration of a processing circuit, a first output unit, and a second output unit.
Fig. 4 is a diagram illustrating an example of a configuration of a second output unit.
Fig. 5 is a diagram illustrating an example of a configuration of an output unit of a photoelectric conversion apparatus.
Fig. 6 is a diagram illustrating an example of a configuration of a transmitter of an output unit.
Fig. 7 is a diagram illustrating an example of operations of a decoder.
Fig. 8 is a diagram illustrating an example of an operation of the transmitter.
Fig. 9 is a diagram illustrating an example of the operation of the transmitter.
Fig. 10 is a diagram illustrating an example of the operation of the transmitter.
Fig. 11 is a diagram illustrating an example of the operation of the transmitter.
Fig. 12 is a diagram illustrating an example of an operation of the transmitter.
Fig. 13 is a diagram illustrating a transmitter according to a first modified example.
Fig. 14 is a diagram illustrating a transmitter according to a second modified example.
Fig. 15 is a diagram illustrating an example of a configuration of a system including a photoelectric conversion apparatus.
Fig. 16 is a diagram illustrating how a photoelectric conversion apparatus is driven.
Fig. 17 is a diagram illustrating how a photoelectric conversion apparatus is driven.
Fig. 18 is a diagram illustrating how a photoelectric conversion apparatus is driven.
Fig. 19 is a diagram illustrating an example of a configuration of a photoelectric conversion system.
Figs. 20A and 20B are diagrams illustrating examples of configurations of a photoelectric conversion system and a moving object.
Fig. 21 is a diagram illustrating an example of an operation of a photoelectric conversion system.

### DESCRIPTION OF THE EMBODIMENTS

Hereinafter, embodiments will be described in detail with reference to the accompanying drawings. Note that the embodiments described below are not intended to limit the disclosure according to the claims. Although a plurality of features is described in the embodiments, not all of the features are necessarily essential to the disclosure, and the features may be combined as appropriate. Further, in the accompanying drawings, the same reference numerals are assigned to the same or similar components, and redundant descriptions are omitted.

In the present specification, terms indicating specific directions or positions (for example, "upper," "lower," "right," and "left," and other terms including these terms) are used as necessary. These terms are used to facilitate understanding of the embodiments with reference to the drawings, and the technical scope of the present disclosure is not limited by the meanings of these terms.

In the present specification, when it is stated that "a member A and a member B are electrically connected," this is not limited to a case where the member A and the member B are directly connected. For example, even if another member C is connected between the member A and the member B, it is sufficient that the member A and the member B are electrically connected.

In the present specification, the term "plane" refers to a surface in a direction parallel to a principal surface of a substrate. The principal surface of the substrate may be a light incidence surface of a substrate including a photoelectric conversion element, a surface on which a plurality of analog-to-digital conversion circuits is repeatedly arranged, or a bonding surface between substrates in a stacked photoelectric conversion apparatus.

Further, the term "plan view" refers to viewing from a direction perpendicular to the principal surface of the substrate. Moreover, the term "cross section" refers to a surface in a direction perpendicular to the light incidence surface of the substrate. Further, the term "cross-sectional view" refers to viewing from a direction parallel to the principal surface of the substrate.

In the present specification, metal members such as wiring and pads described herein may be made of a single-element metal consisting of one element, or may be a mixture (alloy). For example, wiring described as copper wiring may be made of copper alone, or may have a composition that mainly contains copper and further contains other components. Further, for example, a pad connected to an external terminal may be made of aluminum alone, or may have a composition that mainly contains aluminum and further contains other components. The copper wiring and the aluminum pad described herein are merely examples, and can be changed to various types of metal. Further, the wiring and the pad described herein are merely examples of the metal members used in the photoelectric conversion apparatus, and may also be applicable to other metal members.

The relationships "substantially equal," "substantially identical," and "substantially parallel" in the present disclosure will be described.

Although the relationships are designed to be an equal relationship, an identical relationship, and a parallel relationship, a slight difference may occur due to a manufacturing error. The terms "substantially equal," "substantially identical," and "substantially parallel" include such a slight difference caused by this manufacturing error.

### First Embodiment

A photoelectric conversion apparatus PEC according to a first embodiment will be described. The photoelectric conversion apparatus PEC may, for example, be configured as an image capturing apparatus or another apparatus such as a ranging apparatus or light metering apparatus. The ranging apparatus may, for example, be configured as a focus detecting apparatus or a Time-of-Flight (TOF) ranging apparatus. The light metering apparatus may, for example, be configured to measure a light intensity distribution within a field of view of a camera.

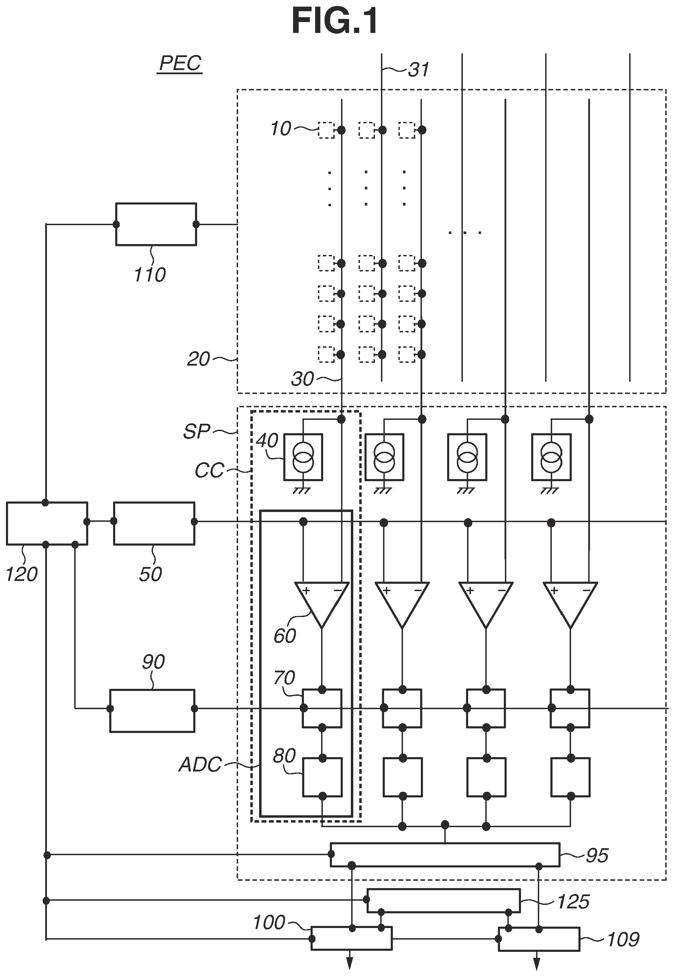

Fig. 1 schematically illustrates a configuration of the photoelectric conversion apparatus PEC. The photoelectric conversion apparatus PEC may be configured in the form of a semiconductor chip. The semiconductor chip may include a stacked structure of a plurality of substrates, and the photoelectric conversion apparatus PEC includes a substrate portion including a single substrate or a plurality of stacked substrates. The photoelectric conversion apparatus PEC may include, for example, a pixel array 20, a signal processing portion SP, and a row selection circuit (vertical scanning circuit) 110. The signal processing portion SP may include a plurality of column circuits CC. The pixel array 20 may include a plurality of pixels 10 and a plurality of vertical signal lines. The plurality of pixels 10 may be arranged to form a plurality of rows and columns. A row selection circuit 110 may be configured to select the plurality of rows, each composed of the plurality of pixels 10, in the pixel array 20 in a predetermined order on a row-by-row basis.

In the example illustrated in Fig. 1, the plurality of vertical signal lines of the pixel array 20 includes vertical signal lines 30 corresponding to odd-numbered columns, and vertical signal lines 31 corresponding to even-numbered columns. While different reference numerals are assigned to the odd-numbered columns and the even-numbered columns, this is not intended to limit the disclosure. Further, in the example illustrated in Fig. 1, column circuits (the plurality of column circuits CC in Fig. 1) configured to process signals output downward through the vertical signal lines 30 corresponding to odd-numbered columns, and column circuits (not illustrated) configured to process signals output upward through the vertical signal lines 31 corresponding to even-numbered columns, may be provided apart from each other. While the column circuits CC corresponding to the even-numbered columns and the column circuits CC corresponding to the odd-numbered columns are disposed in two regions herein, the column circuits CC corresponding to the even-numbered columns and the column circuits CC corresponding to the odd-numbered columns may be disposed in a single region.

While the column circuits CC that process signals of the odd-numbered columns will be described, the column circuits CC that process signals of the even-numbered columns may have configurations similar to those of the column circuits CC that process signals of the odd-numbered columns.

Each column circuit CC may, for example, include a current supply circuit 40 configured to cause current to flow in the vertical signal line 30 corresponding to the column circuit CC among the plurality of vertical signal lines 30. Each column circuit CC includes a comparator 60 configured to compare a value of a signal supplied from the vertical signal line 30 corresponding to the column circuit CC and a value of a ramp signal supplied from a ramp signal generating circuit 50. Each column circuit CC includes a first memory 70 configured to hold a count value supplied from a counter 90 in response to inversion of output of the comparator 60.

The counter 90 may be provided commonly for the plurality of vertical signal lines 30, or may be provided individually for each vertical signal line 30. The comparator 60 and the first memory 70 form an analog-to-digital (AD) conversion circuit ADC configured to generate a digital signal corresponding to a signal (analog signal) supplied from the corresponding vertical signal line 30. Each column circuit CC includes a second memory 80 configured to capture a signal (digital signal) held in the first memory 70. The signal processing portion SP or each column circuit CC may include another circuit (e.g., an analog amplification circuit, a correlated double sampling (CDS) circuit).

The signal processing portion SP may include a processing circuit (e.g., digital processing circuit) 95 configured to process signals supplied from the plurality of second memories 80 or the plurality of column circuits CC. The processing circuit 95 may include a column selection circuit (horizontal scanning circuit) configured to select signals output from the plurality of column circuits CC and output the signals in a predetermined order.

The photoelectric conversion apparatus PEC includes a first output unit 100 (first output circuit) and a second output unit 109 (second output circuit). The first output unit 100 outputs a signal generated by processing in the processing circuit 95. The processing circuit 95 may be configured to output an image signal generated using the plurality of pixels 10, or may be configured to output a signal acquired by processing an image signal generated using the plurality of pixels 10.

The photoelectric conversion apparatus PEC includes a control circuit 120 and a fixed signal output unit 125. The control circuit 120 is a circuit configured to control operation timings of the ramp signal generating circuit 50, the counter 90, the processing circuit 95, the row selection circuit 110, the first output unit 100, the second output unit 109, and the fixed signal output unit 125. The fixed signal output unit 125 is a circuit configured to output a fixed-value signal, such as a dummy signal (third signal, fourth signal) or a synchronization signal (fifth signal, sixth signal), to the first output unit 100 and/or the second output unit 109. The fixed-value signal output from the fixed signal output unit 125 may be generated in the fixed signal output unit 125 or in a unit other than the fixed signal output unit 125.

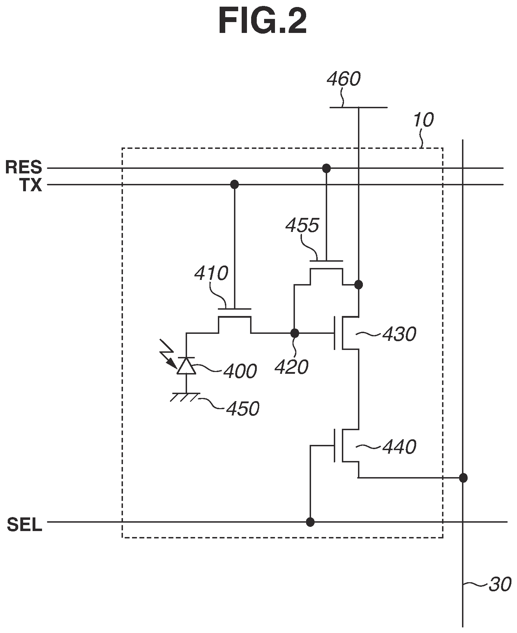

Fig. 2 illustrates an example of a configuration of each pixel 10. The pixel 10 includes a photoelectric conversion element 400. The photoelectric conversion element 400 is, for example, a photodiode. The pixel 10 further includes a floating diffusion 420 and a transfer transistor 410. The transfer transistor 410 transfers a charge generated in the photoelectric conversion element 400 to the floating diffusion 420. A gate of the transfer transistor 410 is connected to a transfer control line TX driven by the row selection circuit 110. The transfer transistor 410 transfers a charge generated in the photoelectric conversion element 400 to the floating diffusion 420 in response to a voltage on the transfer control line TX being driven to an active level. The floating diffusion 420 functions as a charge-voltage conversion portion configured to convert a charge transferred from the photoelectric conversion element 400 by the transfer transistor 410 into a voltage (potential).

The pixel 10 further includes a reset transistor 455 configured to reset a voltage (potential) of the floating diffusion 420. A gate of the reset transistor 455 is connected to a reset control line RES driven by the row selection circuit 110. The reset transistor 455 resets the voltage (potential) of the floating diffusion 420 in response to a voltage on the reset control line RES being driven to an active level. The pixel 10 further includes an amplification transistor 430 configured to output a signal corresponding to the voltage (potential) of the floating diffusion 420 to the vertical signal line 30. The amplification transistor 430 and the current supply circuit 40 described above form a source-follower amplification circuit. The pixel 10 may further include a selection transistor 440 configured to set the pixel 10 to a selected state or a non-selected state. A gate of the selection transistor 440 is connected to a selection control line SEL driven by the row selection circuit 110. The selection transistor 440 sets the pixel 10 to the selected state in response to a voltage on the selection control line SEL being driven to an active level, and sets the pixel 10 to the non-selected state in response to the voltage on the selection control line SEL being driven to an inactive level.

The pixel 10 is not limited to the above-described configuration, and various modifications may be made. For example, the pixel 10 may include an element having a function configured to change a capacitance value of the floating diffusion 420. The pixel 10 may be configured so that a plurality of photoelectric conversion elements 400 shares the floating diffusion 420. The pixel 10 may be configured as a pixel capable of detecting a phase difference using the plurality of photoelectric conversion elements 400 assigned to a single microlens.

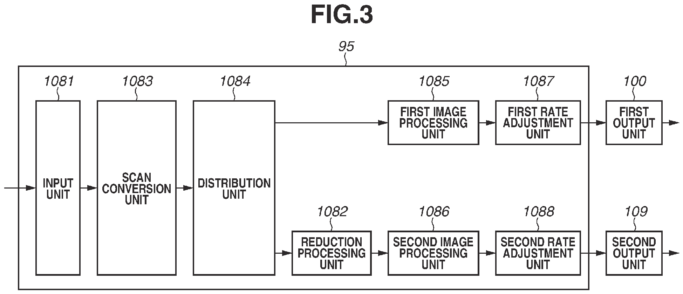

Fig. 3 illustrates an example of a configuration of the processing circuit 95. The processing circuit 95 includes an input unit 1081, a scan conversion unit 1083, a distribution unit 1084, a first image processing unit 1085 (first processing circuit), and a second image processing unit 1086 (second processing circuit). The processing circuit 95 further includes a reduction processing unit 1082, a first rate adjustment unit 1087 (first adjustment circuit), and a second rate adjustment unit 1088 (second adjustment circuit).

The input unit 1081 performs processing, such as noise reduction, on a signal input from the second memory 80, thereby generating image data.

The scan conversion unit 1083 is a circuit configured to change an order of signals read from the second memory 80 by scanning performed by the row selection circuit 110 to an order of signals output from the first output unit 100 and the second output unit 109. For example, signals from six rows of the pixels 10 are input to the scan conversion unit 1083 in parallel. However, when the first output unit 100 or the second output unit 109 outputs signals to the outside of the photoelectric conversion apparatus PEC, signals from each row of the pixels 10 are sequentially output. Accordingly, the scan conversion unit 1083 includes a memory (static random access memory (SRAM)) configured to temporarily store image data output from the input unit 1081. The memory of the scan conversion unit 1083 starts outputting data to the distribution unit 1084 upon accumulation of image data satisfying a signal output order of the first output unit 100 or the second output unit 109.

The distribution unit 1084 includes a function of outputting scan-converted image data to the first image processing unit 1085 and the second image processing unit 1086. For example, in a case where live view (LV) imaging is performed without performing image capturing processing for image recording, the distribution unit 1084 outputs image data to the second image processing unit 1086 without outputting image data to the first image processing unit 1085. As described above, the distribution unit 1084 has a function of switching image data output to the first image processing unit 1085 and the second image processing unit 1086. Further, in a case where the photoelectric conversion apparatus PEC includes a function of performing focus detection using an image-plane phase-difference method, a signal for focus detection and a signal for image recording are generated during image capturing. In this case, for example, in a case where the signal for focus detection is not required during image recording, it is possible to perform control so that the signal for image recording is output to the first image processing unit 1085 without outputting the signal for focus detection.

The first image processing unit 1085 is a circuit configured to mainly process image data for image recording. For example, the first image processing unit 1085 performs a first processing operation, such as dithering processing to reduce quantization error and data compression processing to compress data per pixel.

The first rate adjustment unit 1087 performs a first adjustment operation to adjust an amount of a signal input from the first image processing unit 1085 and output to the first output unit 100. For example, the first rate adjustment unit 1087 intermittently outputs a signal input from the first image processing unit 1085 based on an output data rate of the first output unit 100 to prevent overflow and underflow in the first output unit 100. Further, the first rate adjustment unit 1087 may include a memory for temporarily storing an input signal.

The first output unit 100 is an interface circuit configured to output image data for image recording. The first output unit 100 can set the number of lanes to be used and the number of bits of data per pixel as appropriate. Further, the first output unit 100 can adjust a data rate at output. Further, in the present embodiment, quaternary data is output as a configuration using Pulse Amplitude Modulation with 4 levels (PAM4), thereby performing high-speed communication.

The first output unit 100 is required to support a speed sufficient for continuous high-resolution still image capturing and moving image recording to output data for image recording. Accordingly, the first output unit 100 is provided as a higher-speed interface circuit than the second output unit 109.

For example, in a case where the photoelectric conversion apparatus PEC performs an operation (first operation mode) that does not generate an image for recording, such as during a LV operation, the first image processing unit 1085 and the first output unit 100 can stop operation to reduce power consumption.

The reduction processing unit 1082 is a circuit configured to perform reduction processing on data for LV and data for focus detection to compress an image in horizontal and vertical directions. In general, an image for LV and an image for focus detection may have lower resolution than an image for recording.

The second image processing unit 1086 is a circuit configured to mainly process data for LV and data for focus detection. For example, the second image processing unit 1086 performs a second processing operation, such as dithering processing to reduce quantization error and data compression processing to compress data per pixel.

The second rate adjustment unit 1088 performs a second adjustment operation to adjust an amount of a signal input from the second image processing unit 1086 and output to the second output unit 109. The second rate adjustment unit 1088 intermittently outputs a signal input from the second image processing unit 1086 based on an output data rate of the second output unit 109 to prevent overflow and underflow in the second output unit 109. Further, the second rate adjustment unit 1088 may include a memory for temporarily storing an input signal.

The second output unit 109 is an interface circuit configured to output data for LV and data for focus detection. The second output unit 109 may use the same transmission method as that used by the first output unit 100, or may use a transmission method that is lower in communication speed or uses fewer lanes than that used by the first output unit 100.

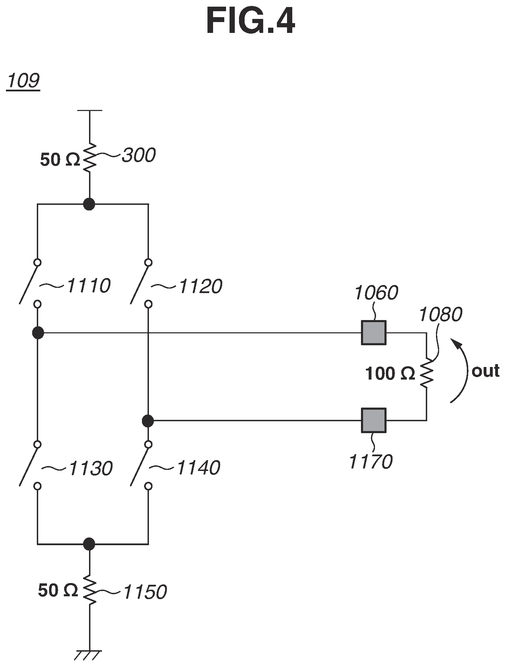

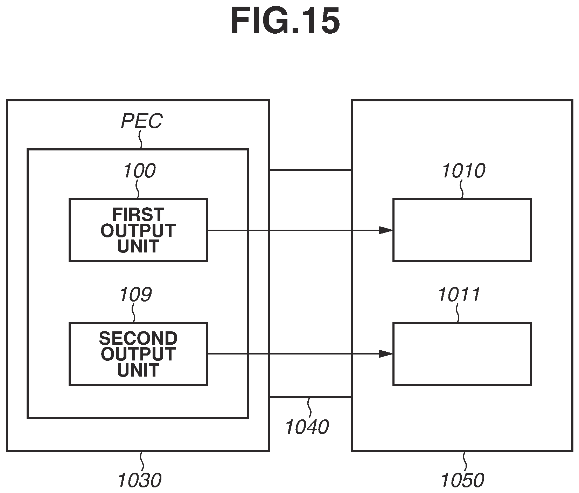

Fig. 4 illustrates an example of a configuration of the second output unit 109. The second output unit 109 may include a transmitter configured to output an amplitude-modulated signal having an amplitude value selected from two (second number) amplitude values. A transmitter illustrated as an example in Fig. 4 may include resistors 300 and 1150, switches 1110, 1120, 1130, and 1140, and output pads 1160 and 1170. Further, a chip (a second signal processing chip 1011 illustrated in Fig. 15) provided outside the photoelectric conversion apparatus PEC may include a resistor 1180 configured to connect the output pads 1160 and 1170. In a case where the switches 1120 and 1130 are on and the switches 1110 and 1140 are off, a negative output amplitude is acquired, and in a case where the switches 1120 and 1130 are off and the switches 1110 and 1140 are on, a positive output amplitude is acquired. In other words, the transmitter illustrated as an example in Fig. 4 has a configuration that performs transmission using two amplitude values. The second output unit 109 is not limited to the configuration illustrated in Fig. 4, and a converter (such as a parallel/serial conversion circuit) configured to convert the format of an input signal may be provided.

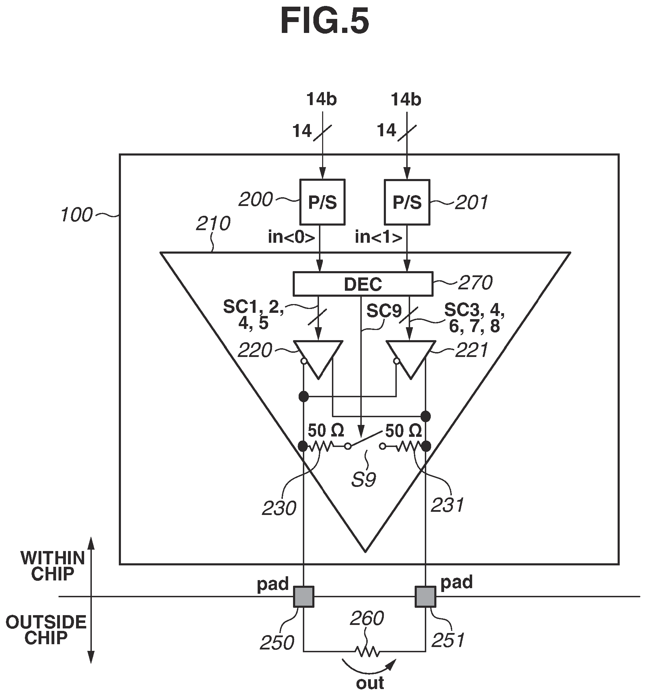

Fig. 5 illustrates an example of a configuration of the first output unit 100. The first output unit 100 performs transmission using three or more (a first number greater than or equal to two) amplitude values. For example, the first output unit 100 performs transmission using four amplitude values. A parallel signal including a plurality of bits may be supplied to the first output unit 100 from the processing circuit 95. A single parallel signal may be a signal from a single pixel 10 (e.g., a signal output from the pixel 10, A/D-converted by the AD conversion circuit ADC, and then processed by the processing circuit 95). In the example illustrated in Fig. 5, two sets of parallel signals each including 14 bits are supplied from the processing circuit 95 to the first output unit 100. The photoelectric conversion apparatus PEC may be configured as a semiconductor chip and include output pads 250 and 251. The output pads 250 and 251 may be connected to each other by a termination resistor 260 provided outside the semiconductor chip. For example, the termination resistor 260 is provided to a first signal processing chip 1010 illustrated in Fig. 15.

For example, the first output unit 100 may include parallel serial conversion circuits 200 and 201 and a transmitter 210. In one example, a signal from a single pixel 10 may be supplied as a parallel signal (parallel data) simultaneously or in parallel from the processing circuit 95 to the parallel serial conversion circuit 200 (first conversion circuit). Further, a signal from another single pixel 10 may be supplied as a parallel signal (parallel data) simultaneously or in parallel from the processing circuit 95 to the parallel serial conversion circuit 201. Each of the parallel serial conversion circuits 200 and 201 may convert the supplied parallel signal into a serial signal (first conversion operation) and supply the serial signal to the transmitter 210. In the example illustrated in Fig. 5, the parallel serial conversion circuit 200 converts the supplied parallel signal into a serial signal and supplies the serial signal as a serial signal in<0> to the transmitter 210. Further, the parallel serial conversion circuit 201 may convert the supplied parallel signal into a serial signal and supply the serial signal as a serial signal in<1> to the transmitter 210.

In the example illustrated in Fig. 5, the transmitter 210 includes a configuration that outputs an amplitude-modulated signal including 2 bits of information at a time. In other words, the transmitter 210 includes a configuration that outputs an amplitude-modulated signal having an amplitude value selected from four amplitude values. However, the transmitter 210 may include a configuration that outputs an amplitude-modulated signal having an amplitude value selected from any number of amplitude values that is greater than or equal to three (e.g., four, six, or eight). In the example illustrated in Fig. 5, the transmitter 210 includes a decoder 270, 1-bit transmitters 220 and 221, resistors 230 and 231, and a switch S9.

For example, at a predetermined timing, a least significant bit (LSB) value of a 14-bit parallel signal from a single pixel 10 is supplied as a serial signal in<0> from the parallel serial conversion circuit 200 to the transmitter 210 (the decoder 270). Further, at the same time, an LSB value of a 14-bit parallel signal from another single pixel 10 is supplied as a serial signal in<1> from the parallel serial conversion circuit 201 to the transmitter 210 (the decoder 270). The transmitter 210 outputs an amplitude-modulated signal having an amplitude value selected from four amplitude values based on the two inputs as a differential output voltage out between the output pads 250 and 251 (between both ends of the termination resistor 260). In other words, the amplitude-modulated signal or the differential output voltage out output by the transmitter 210 between the output pads 250 and 251 (between both ends of the termination resistor 260) may have one of four amplitude values based on the values of the two serial signals in<1> and in<0>. In this manner, the first output unit 100 outputs a signal including 2 bits of information from the output pads 250 and 251 at a time.

This makes it possible to improve the signal transfer rate from the photoelectric conversion apparatus PEC to another apparatus. Further, in another aspect, the photoelectric conversion apparatus PEC makes it possible to suppress an increase in the number of output pads required to output a signal from the pixel array 20 while improving the signal transfer rate from the photoelectric conversion apparatus PEC to another apparatus. This is effective in increasing the number of power supply potential pads and the number of ground potential pads for the pixel array 20, the comparator 60 (AD conversion circuit), the first memory 70, the second memory 80, and the like, and suppressing deterioration in image quality.

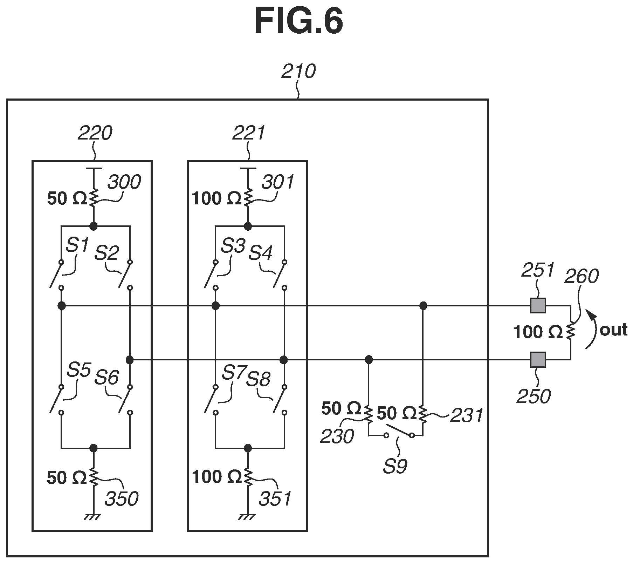

Fig. 6 illustrates an example of a configuration of the 1-bit transmitters 220 and 221 included in the transmitter 210. The 1-bit transmitter 220 may, for example, include the resistor 300, switches S1, S2, S5, and S6, and a resistor 350. Similarly, the 1-bit transmitter 221 may, for example, include a resistor 301, switches S3, S4, S7, and S8, and a resistor 351. In the example illustrated in Fig. 6, the resistors 300 and 350 of the 1-bit transmitter 220 and the resistors 301 and 351 of the 1-bit transmitter 221 have different values. Specifically, the resistors 300 and 350 have 50 Ω, whereas the resistors 301 and 351 have 100 Ω. The transmitter 210 further includes the resistors 230 and 231 and the switch S9.

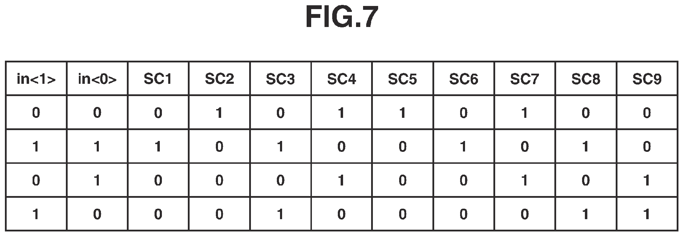

Fig. 7 illustrates an example of operations of the decoder 270. The decoder 270 may include input terminals configured to receive serial signals in<1> and in<0> and output terminals configured to output switch control signals SC1 to SC9. The switch control signals SC1 to SC9 are supplied to the switches S1 to S9, respectively. In this example, in a case where the switch control signals SC1 to SC9 have a value of 1, the switches S1 to S9 are in an on state (conductive state), whereas in a case where the switch control signals SC1 to SC9 have a value of 0, the switches S1 to S9 are in an off state (non-conductive state).

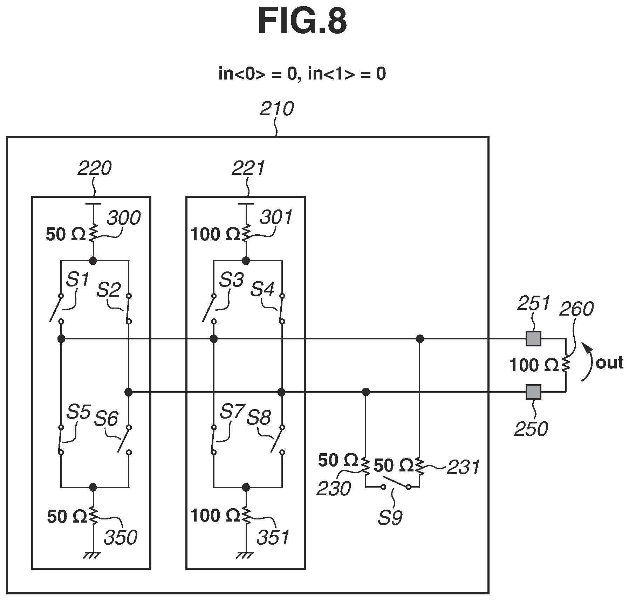

Fig. 8 illustrates operation states of the switches S1 to S9 in the transmitter 210 for a case where the serial signal in<1> is 0 and the serial signal in<0> is 0. As illustrated in Fig. 8, the switches S2, S4, S5, and S7 are in an on state, and the other switches S1, S3, S6, S8, and S9 are in an off state. In a case where the switches S2 and S4 are in an on state, the resistors 300 and 301 are connected in parallel between the power supply potential and the output pad 250, and the combined resistance thereof is approximately 33 Ω. Further, in a case where the switches S5 and S7 are in an on state, the resistors 350 and 351 are connected in parallel between the ground potential and the output pad 251, and the combined resistance thereof is approximately 33 Ω. For example, in a case where the power supply potential is 0.5 V, the output pad 250 has a potential of 400 mV, and the output pad 251 has a potential of 100 mV. Therefore, the differential output voltage out is -300 mV.

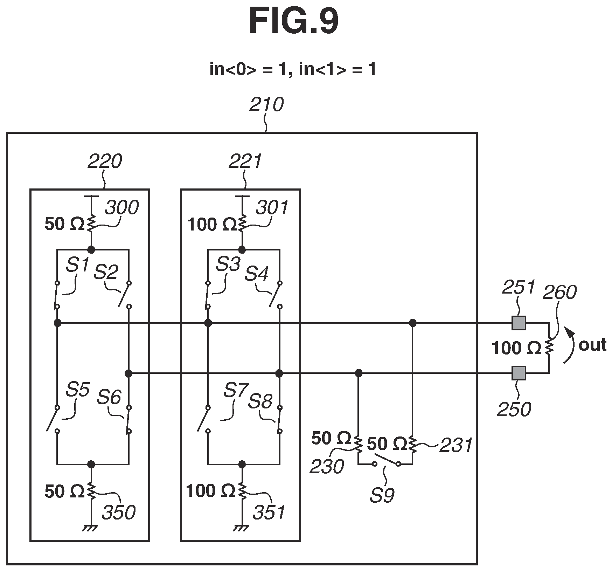

Fig. 9 illustrates operation states of the switches S1 to S9 in the transmitter 210 for a case where the serial signal in<1> is 1 and the serial signal in<0> is 1. As illustrated in Fig. 9, the switches S1, S3, S6, and S8 are in an on state, and the other switches S2, S4, S5, S7, and S9 are in an off state. In a case where the switches S1 and S3 are in an on state, the resistors 300 and 301 are connected in parallel between the power supply potential and the output pad 251, and the combined resistance thereof is approximately 33 Ω. Further, in a case where the switches S6 and S8 are in an on state, the resistors 350 and 351 are connected in parallel between the ground potential and the output pad 250, and the combined resistance thereof is approximately 33 Ω. For example, in a case where the power supply potential is 0.5 V, the output pad 251 has a potential of 400 mV, and the output pad 250 has a potential of 100 mV. Therefore, the differential output voltage out is +300 mV.

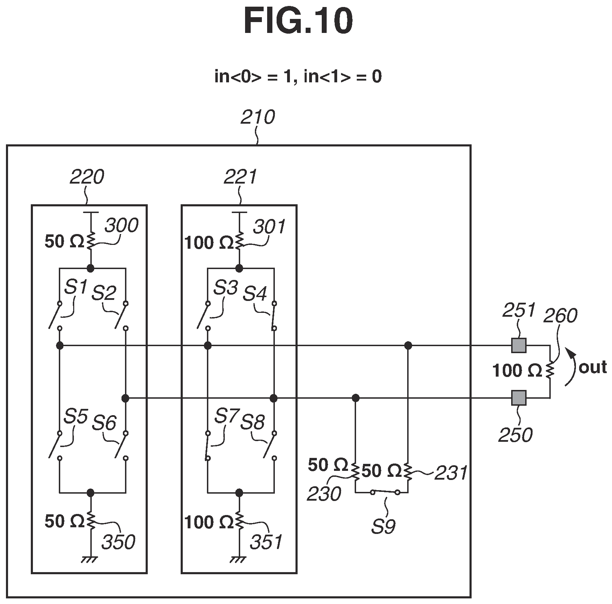

Fig. 10 illustrates operation states of the switches S1 to S9 in the transmitter 210 for a case where the serial signal in<1> is 0 and the serial signal in<0> is 1. As illustrated in Fig. 10, the switches S4, S7, and S9 are in an on state, and the other switches S1, S2, S3, S5, S6, and S8 are in an off state. In a case where the switch S4 is in an on state, the resistor 301 is connected between the power supply potential and the output pad 250, and the resistance thereof is 100 Ω. Further, in a case where the switch S7 is in an on state, the resistor 351 is connected between the ground potential and the output pad 251, and the resistance thereof is 100 Ω. Further, in a case where the switch S9 is in an on state, the resistors 230 and 231 are connected between the output pads 250 and 251, in addition to the termination resistor 260, and the combined resistance thereof is 50 Ω. Accordingly, for example, in a case where the power supply potential is 0.5 V, the output pad 250 has a potential of 300 mV, and the output pad 251 has a potential of 200 mV. Therefore, the differential output voltage out is -100 mV.

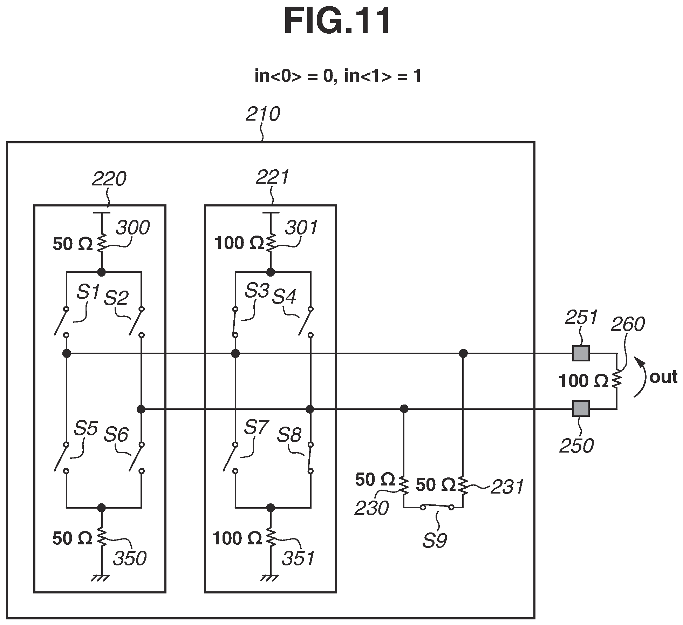

Fig. 11 illustrates operation states of the switches S1 to S9 in the transmitter 210 in a case where the serial signal in<1> in Fig. 5 is 1 and the serial signal in<0> in Fig. 5 is 0. As illustrated in Fig. 11, the switches S3, S8, and S9 are in an on state, and the other switches S1, S2, S4, S5, S6, and S7 are in an off state. In a case where the switch S3 is in an on state, the resistor 301 is connected between the power supply potential and the output pad 251, and the resistance thereof is 100 Ω. Further, in a case where the switch S8 is in an on state, the resistor 351 is connected between the ground potential and the output pad 250, and the resistance thereof is 100 Ω. Further, in a case where the switch S9 is in an on state, the resistors 230 and 231 are connected between the output pad 250 and the output pad 251, in addition to the termination resistor 260, and the combined resistance thereof is 50 Ω. Accordingly, for example, in a case where the power supply potential is 0.5 V, the output pad 251 has a potential of 300 mV, and the output pad 250 has a potential of 200 mV. Therefore, the differential output voltage out is +100 mV.

Accordingly, in the example illustrated in Fig. 6, the first output unit 100 includes a voltage divider circuit having a variable voltage division ratio, and an output signal of the first output unit 100, i.e., an amplitude-modulated signal, is generated by changing the voltage division ratio of the voltage divider circuit. The voltage division ratio is controlled by the decoder 270 configured to generate the switch control signals SC1 to SC9 based on the serial signals in<1> and in<0>.

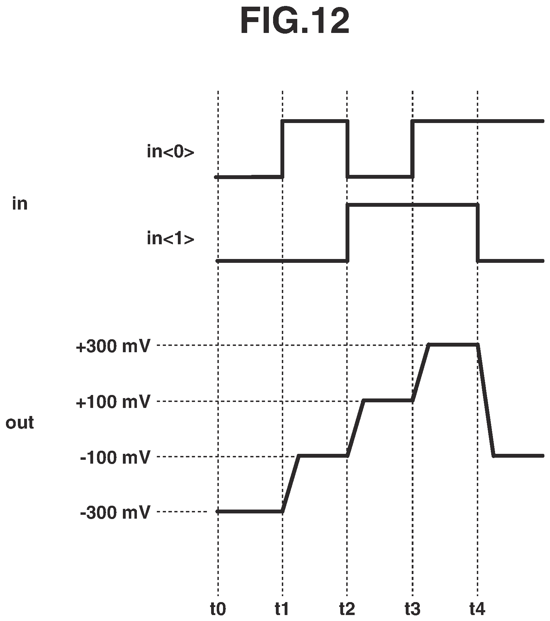

Fig. 12 illustrates four amplitude values of a differential output signal out of the first output unit 100 that correspond to four possible input values of the serial signals in<1> and in<0>. In the examples described with reference to Figs. 6 to 12, the first output unit 100 or the transmitter 210 outputs an amplitude-modulated signal having an amplitude value selected from four amplitude values.

While the signal from each pixel 10 is 14 bits in the example illustrated in Fig. 5, this is merely an example, and the present disclosure is not limited thereto. The signal from each pixel 10 may be quantized to any number of bits, such as 10, 12, or 16 bits.

Further, in the example illustrated in Fig. 5, the value of a bit (e.g., LSB) of a digital signal from a single pixel 10 and the value of the corresponding bit (e.g., LSB) of a digital signal from another single pixel 10 are simultaneously supplied to the transmitter 210. In this case, for example, an amplitude-modulated signal modulated based on the LSB value of the digital signal from the single pixel 10 and the LSB value of the digital signal from the other single pixel 10 is output from the first output unit 100. Then, next, an amplitude-modulated signal modulated based on the values of the second bits of the two pixels is output from the first output unit 100. Thereafter, amplitude-modulated signals modulated based on the values of the third and subsequent bits are sequentially output from the first output unit 100, and lastly, an amplitude-modulated signal modulated based on most significant bit (MSB) values of the digital signals from the two pixels is output from the first output unit 100.

The foregoing configuration is advantageous in that a configuration of a signal processing portion of an external apparatus (e.g., a processor) configured to receive an amplitude-modulated signal output from the first output unit 100 of the photoelectric conversion apparatus PEC can be shared with a configuration for receiving a binary output. Specifically, in a case where a digital signal from a single pixel is output in order from the LSB, the second bit, ..., to the MSB for a binary output, signals corresponding to two pixels may be output in order from the LSB, the second bit, ..., to the MSB for a quaternary output. Accordingly, after the signals corresponding to two pixels are first separated (decoded), the same signal processing as in the binary output case may be performed. However, another configuration may be employed, such as a configuration that simultaneously outputs LSB and MSB values of the same pixel.

The resistance values of the resistors 300, 301, 350, 351, 230, and 231 are merely examples. These resistance values may be adjusted to adjust the amplitude of an output signal and an output resistance. For example, the resistors 300 and 350 may be configured to have a resistance greater than 50 Ω, such as 60 Ω or 70 Ω. At this time, the amplitude of the output signal is adjusted from ±300 mV in Fig. 12 toward a smaller absolute value.

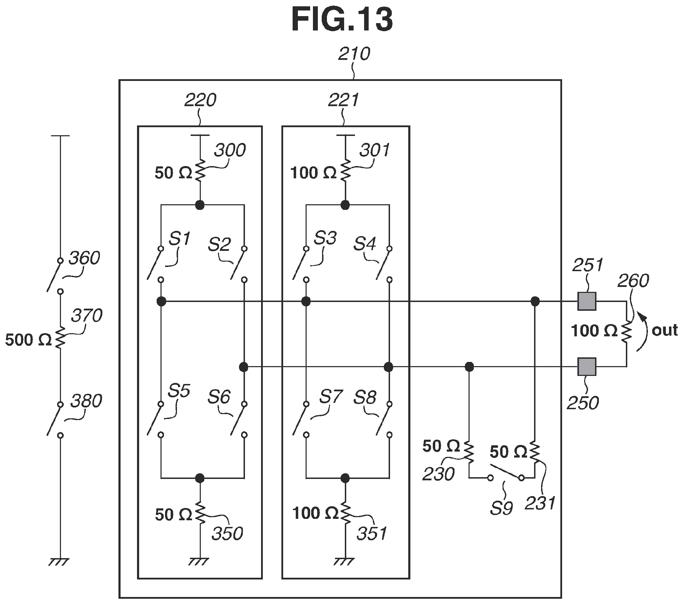

Fig. 13 illustrates a first modified example of the transmitter 210 of the photoelectric conversion apparatus PEC in the first embodiment. In the first modified example, the transmitter 210 may include switches 360 and 380 and a resistor 370 connected in series between a power supply potential line and a ground potential line, in addition to the above-described configuration. In the operation state illustrated in Fig. 8 or 9, i.e., in<1> = 0 and in<0> = 0 or in<1> = 1 and in<0> = 1, the switches 360 and 380 are in an off state. On the other hand, in the operation state illustrated in Fig. 10 or 11, i.e., in<1> = 0 and in<0> = 1 or in<1> = 1 and in<0> = 0, the switches 360 and 380 are in an on state. This suppresses variations in the current consumption of the transmitter 210 corresponding to changes in the combination of values of the serial signals in<1> and in<0>. Accordingly, variations in the power supply potential and the ground potential of the transmitter 210 are suppressed, enabling stable operation of the transmitter 210. The effect of variations in the current consumption of the transmitter 210 on the signal processing portion SP may be reduced, and deterioration in image quality may be suppressed.

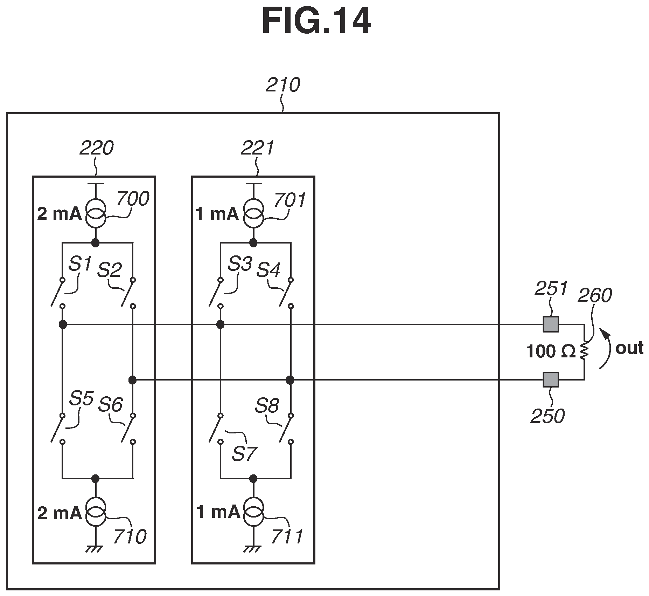

Fig. 14 illustrates a second modified example of the transmitter 210 of the photoelectric conversion apparatus PEC in the first embodiment. In the second modified example, the resistors 300, 301, 350, and 351 of the transmitter 210 in the first embodiment are replaced by current sources 700, 701, 710, and 711. With this configuration, variations in the current consumption of the transmitter 210 corresponding to changes in the combination of values of the serial signals in<1> and in<0> are suppressed. However, in a case where a current source is used, it is required to maintain the voltage across both terminals of the current source at or above a predetermined value. Thus, from the viewpoint of low voltage and low power, the configuration illustrated in Fig. 13 can be employed.

Other modified examples will be described. While a single first vertical signal line is provided for each pixel column in the above-described examples, a configuration in which a plurality of first vertical signal lines is provided for each pixel column to read signals from pixels in a plurality of rows simultaneously may be employed. The comparator 60 may be configured to include a capacitor and switch for auto-zero operation.

The photoelectric conversion apparatus PEC may include three or more substrates stacked on top of one another, or may include a single substrate. Further, the photoelectric conversion apparatus PEC may be a front-illuminated type or a back-illuminated type.

Fig. 15 illustrates an example of a configuration of a photoelectric conversion system including substrates 1030 and 1050. The photoelectric conversion apparatus PEC is mounted on a printed circuit board different from that on which a signal processing chip is mounted. In the example illustrated in Fig. 15, the photoelectric conversion apparatus PEC is mounted on the substrate 1030, which is a printed circuit board for a sensor. Further, the first signal processing chip 1010 (first signal processing circuit) and the second signal processing chip 1011 (second signal processing circuit) are mounted on the substrate 1050, which is a printed circuit board for signal processing. The substrates 1030 and 1050 are connected by a flexible printed circuit board 1040, whereby a system may be configured. Data output from the first output unit 100 of the photoelectric conversion apparatus PEC is transmitted to the first signal processing chip 1010 via a transmission line in the substrate 1030, a transmission line in the flexible printed circuit board 1040, and a transmission line in the substrate 1050. Further, data output from the second output unit 109 of the photoelectric conversion apparatus PEC is transmitted to the second signal processing chip 1011 via a transmission line in the substrate 1030, a transmission line in the flexible printed circuit board 1040, and a transmission line in the substrate 1050. In the present embodiment, the transmitter 210 is configured to have four possible amplitude values, thereby making it possible to reduce the number of traces included in the flexible printed circuit board 1040, in addition to the number of transmission lines. This is advantageous in reducing the size of the flexible printed circuit board and radiated noise associated with signal transmission in the flexible printed circuit board. The flexible printed circuit board 1040 is merely an example of a connection unit, and in place of the flexible printed circuit board 1040, for example, a coaxial cable or the like may be used.

As another form, a configuration in which the photoelectric conversion apparatus PEC, the first signal processing chip 1010, and the second signal processing chip 1011 are mounted on the same substrate may be employed.

The first signal processing chip 1010 mainly performs processing for generating an image for recording. Further, the second signal processing chip 1011 mainly performs processing for generating an image for LV and processing for data for focus detection.

In another system, the photoelectric conversion apparatus PEC may output an image signal to a preprocessing chip, and the preprocessing chip may output an image signal to a signal processing chip. In this configuration, signal transmission from the preprocessing chip to the signal processing chip may be performed using only two amplitude values, or may be performed using three or more amplitude values.

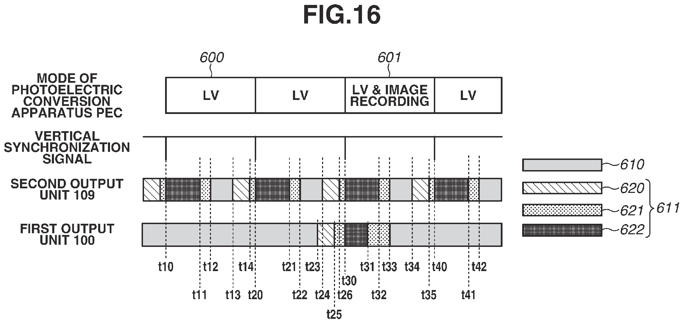

Fig. 16 illustrates an example of a timing chart of the photoelectric conversion apparatus PEC. Fig. 16 illustrates a timing chart in a case where a first mode 600 and a second mode 601 are switched during a still image capturing mode. The first mode 600 is a mode during which the photoelectric conversion apparatus PEC outputs data for LV. During the first mode 600, the first output unit 100 is in a power-saving state 610, and the second output unit 109 configured to output data for LV is in an operation state 611. The second mode 601 is a mode during which the photoelectric conversion apparatus PEC outputs data for LV and data for image recording. During the second mode 601, the first output unit 100 configured to output data for image recording and the second output unit 109 configured to output data for LV are in the operation state 611. Upon transition from the first mode 600 to the second mode 601, the first output unit 100 and the second output unit 109 may be in the operation state 611 even before the second mode 601 starts. During the first mode 600, the second output unit 109 may transition from the operation state 611 to the power-saving state 610. During the second mode 601, the first output unit 100 and the second output unit 109 may transition from the operation state 611 to the power-saving state 610.

In a case where the first output unit 100 is in the operation state 611, the first output unit 100 is connected to the first signal processing chip 1010. On the other hand, in a case where the first output unit 100 is in the power-saving state 610, the first output unit 100 is not connected to the first signal processing chip 1010, and outputs no signal.

In a case where the first output unit 100 is in the operation state 611, the first output unit 100 sequentially transitions through a calibration state 620, a dummy data output state 621, and a valid data output state 622. In the calibration state 620, the first output unit 100 outputs a synchronization signal to initiate connection to the first signal processing chip 1010. The synchronization signal includes a plurality of fixed values and is output to synchronize the first signal processing chip 1010 with the first output unit 100. The duration of the calibration state 620 required for the first output unit 100 to connect to the first signal processing chip 1010 differs depending on the output format. In the dummy data output state 621, the first output unit 100 outputs a dummy signal to maintain a connection with the first signal processing chip 1010. The dummy signal includes a single fixed value. In the valid data output state 622, the first output unit 100 outputs a signal to cause predetermined processing to be performed in the first signal processing chip 1010.

The relationship between the second output unit 109 and the second signal processing chip 1011 in the power-saving state 610 and the operation state 611 is similar to that between the first output unit 100 and the first signal processing chip 1010.

The first output unit 100 has lower power consumption in the power-saving state 610 than in the operation state 611. For example, in a case where the first output unit 100 is in the power-saving state 610, the first rate adjustment unit 1087 does not perform the adjustment operation described above. For example, in a case where the first output unit 100 is in the power-saving state 610, the first image processing unit 1085 does not perform the processing operation described above.

For example, in a case where the first output unit 100 is in the power-saving state 610, the parallel serial conversion circuits 200 and 201 do not perform the conversion operation described above. For example, in a case where the first output unit 100 is in the power-saving state 610, the reduction processing unit 1082 does not perform the reduction processing described above.

The second output unit 109 has lower power consumption in the power-saving state 610 than in the operation state 611. For example, in a case where the second output unit 109 is in the power-saving state 610, the second rate adjustment unit 1088 does not perform the adjustment operation described above. For example, in a case where the second output unit 109 is in the power-saving state 610, the second image processing unit 1086 does not perform the processing operation described above.

For example, in a case where the second output unit 109 is in the power-saving state 610, the parallel serial conversion circuits 200 and 201 do not perform the conversion operation described above.

In Fig. 16, the first mode 600 occurs during the period from time t10 to time t30 and the period from time t40 onward. Further, the second mode 601 occurs during the period from time t30 to time t40.

Fig. 16 illustrates a case where the first mode 600 occurs during the period before time t20 and is maintained at time t20. At time t13 before time t20, the second output unit 109 transitions from the power-saving state 610 to the operation state 611.

During the period from time t13 to time t14, the second output unit 109 is in the calibration state 620. A calibration period of a predetermined time is required for the second output unit 109 to connect to the second signal processing chip 1011. Accordingly, the period from time t13 to time t14 is set to equal or exceed the predetermined time.

Next, during the period from time t14 to time t20, the second output unit 109 is in the dummy data output state 621. During this period, the second output unit 109 outputs a dummy signal to the second signal processing chip 1011. For example, the second output unit 109 transitions from the dummy data output state 621 to the valid data output state 622 upon input of data for LV to the second output unit 109.

Next, during the period from time t20 to time t21, the second output unit 109 is in the valid data output state 622. During this period, the second output unit 109 outputs data for LV to the second signal processing chip 1011. For example, upon completion of output of data for LV from the second output unit 109 to the second signal processing chip 1011, the second output unit 109 transitions from the valid data output state 622 to the dummy data output state 621.

Next, during the period from time t21 to time t22, the second output unit 109 is in the dummy data output state 621. During this period, the second output unit 109 outputs a dummy signal to the second signal processing chip 1011.

Thereafter, at time t22, the second output unit 109 transitions from the operation state 611 to the power-saving state 610. In a case where the second output unit 109 transitions from the operation state 611 to the power-saving state 610 while the first output unit 100 is in the valid data output state 622, noise caused by a power fluctuation may occur. Accordingly, the first output unit 100 cannot be in the valid data output state 622 during the transition of the second output unit 109 from the operation state 611 to the power-saving state 610. Thus, at time t22, the first output unit 100 is, for example, in the power-saving state 610.

Fig. 16 illustrates a case where a transition from the first mode 600 to the second mode 601 occurs at time t30. At time t23 before time t30, the first output unit 100 transitions from the power-saving state 610 to the operation state 611. At time t24 before time t30, the second output unit 109 transitions from the power-saving state 610 to the operation state 611.

During the period from time t23 to time t25, the first output unit 100 is in the calibration state 620. A calibration period of a predetermined time is required for the first output unit 100 to connect to the first signal processing chip 1010. Accordingly, the period from time t23 to time t25 is set to equal or exceed the predetermined time.

During the period from time t24 to time t26, the second output unit 109 is in the calibration state 620. A calibration period of a predetermined time is required for the second output unit 109 to connect to the second signal processing chip 1011. Accordingly, the period from time t24 to time t26 is set to equal or exceed the predetermined time.

Since the calibration period required for the first output unit 100 is different from the calibration period required for the second output unit 109, the duration from time t23 to time t25 is different from the duration from time t24 to time t26. At least a part of the period of the calibration state 620 of the first output unit 100 may overlap with at least a part of the period of the calibration state 620 of the second output unit 109. The overlap allows the first output unit 100 and the second output unit 109 to perform calibration under the same condition.

Next, during the period from time t25 to time t30, the first output unit 100 is in the dummy data output state 621. During this period, the first output unit 100 outputs a dummy signal to the first signal processing chip 1010. For example, upon input of data for image recording to the first output unit 100, the first output unit 100 transitions from the dummy data output state 621 to the valid data output state 622.

Next, during the period from time t26 to time t30, the second output unit 109 is in the dummy data output state 621. During this period, the second output unit 109 outputs a dummy signal to the second signal processing chip 1011. For example, upon input of data for LV to the second output unit 109, the second output unit 109 transitions from the dummy data output state 621 to the valid data output state 622.

Next, during the period from time t30 to time t31, the first output unit 100 is in the valid data output state 622. During this period, the first output unit 100 outputs data for image recording to the first signal processing chip 1010. For example, upon completion of output of data for image recording from the first output unit 100 to the first signal processing chip 1010, the first output unit 100 transitions from the valid data output state 622 to the dummy data output state 621.

Next, during the period from time t30 to time t32, the second output unit 109 is in the valid data output state 622. During this period, the second output unit 109 outputs data for LV to the second signal processing chip 1011. For example, upon completion of output of data for LV from the second output unit 109 to the second signal processing chip 1011, the second output unit 109 transitions from the valid data output state 622 to the dummy data output state 621.

Next, during the period from time t31 to time t33, the first output unit 100 is in the dummy data output state 621. During this period, the first output unit 100 outputs a dummy signal to the second signal processing chip 1011.

Next, during the period from time t32 to time t33, the second output unit 109 is in the dummy data output state 621. During this period, the second output unit 109 outputs a dummy signal to the second signal processing chip 1011.

Thereafter, at time t33, the first output unit 100 and the second output unit 109 transition from the operation state 611 to the power-saving state 610. At time t33, the first output unit 100 and the second output unit 109 are not required to simultaneously transition from the operation state 611 to the power-saving state 610.

In a case where the first output unit 100 transitions from the operation state 611 to the power-saving state 610 while the second output unit 109 is in the valid data output state 622, noise caused by a power fluctuation may occur. Accordingly, it is desirable that the second output unit 109 not be in the valid data output state 622 during the transition of the first output unit 100 from the operation state 611 to the power-saving state 610. In a case where the second output unit 109 transitions from the operation state 611 to the power-saving state 610 while the first output unit 100 is in the valid data output state 622, noise caused by a power fluctuation may occur. Accordingly, it is desirable that the first output unit 100 not be in the valid data output state 622 during the transition of the second output unit 109 from the operation state 611 to the power-saving state 610.

In the present embodiment, the first output unit 100 is in the power-saving state 610 when the second output unit 109 is in the operation state 611, thereby making it possible to reduce power consumption in a configuration in which amplitude-modulated signals having amplitude values selected from different amplitude values are output. The second output unit 109 may be in the power-saving state 610 when the first output unit 100 is in the operation state 611. Even in this case, it is possible to reduce power consumption in a configuration in which amplitude-modulated signals having amplitude values selected from different amplitude values are output.

### Second Embodiment

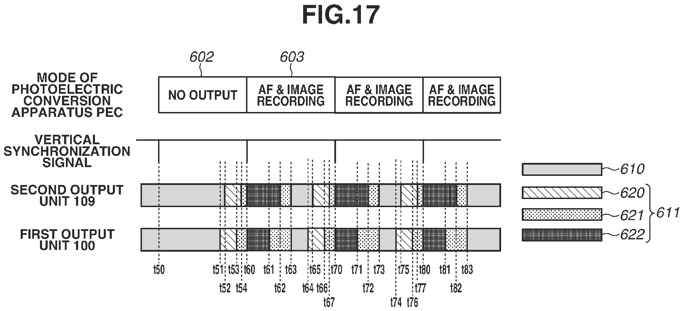

A photoelectric conversion apparatus according to a second embodiment of the present disclosure will be described with reference to Fig. 17. Note that components similar to those in the first embodiment are denoted by the same reference numerals, and descriptions of these components may be omitted or simplified.

Fig. 17 illustrates an example of a timing chart of the photoelectric conversion apparatus PEC. Fig. 17 illustrates a timing chart for a case where a third mode 602 and a fourth mode 603 are switched during a moving image capturing mode. The third mode 602 is a mode during which the photoelectric conversion apparatus PEC does not output data. During the third mode 602, the first output unit 100 and the second output unit 109 are in the power-saving state 610. The fourth mode 603 is a mode during which the photoelectric conversion apparatus PEC outputs data for focus detection and data for image recording. During the fourth mode 603, the first output unit 100 configured to output data for image recording and the second output unit 109 configured to output data for focus detection are in the operation state 611. Upon transition from the third mode 602 to the fourth mode 603, the first output unit 100 and the second output unit 109 may be in the operation state 611 even before the fourth mode 603 starts. During the fourth mode 603, the first output unit 100 and the second output unit 109 may transition from the operation state 611 to the power-saving state 610.

In Fig. 17, the third mode 602 occurs during the period from time t50 to time t60. Further, the fourth mode 603 occurs during the period from time t60 onward.

Fig. 17 illustrates a case where a transition from the third mode 602 to the fourth mode 603 occurs at time t60. At time t51 before time t60, the first output unit 100 transitions from the power-saving state 610 to the operation state 611. At time t52 before time t60, the second output unit 109 transitions from the power-saving state 610 to the operation state 611.

During the period from time t51 to time t53, the first output unit 100 is in the calibration state 620. A calibration period of a predetermined time is required for the first output unit 100 to connect to the first signal processing chip 1010. Accordingly, the period from time t51 to time t53 is set to equal or exceed the predetermined time.

During the period from time t52 to time t54, the second output unit 109 is in the calibration state 620. A calibration period of a predetermined time is required for the second output unit 109 to connect to the second signal processing chip 1011. Accordingly, the period from time t52 to time t54 is set to equal or exceed the predetermined time.

Since the calibration period required for the first output unit 100 is different from the calibration period required for the second output unit 109, the duration from time t51 to time t53 is different from the duration from time t52 to time t54. At least a part of the period of the calibration state 620 of the first output unit 100 may overlap with at least a part of the period of the calibration state 620 of the second output unit 109. The overlap allows the first output unit 100 and the second output unit 109 to perform calibration under the same condition.

Next, during the period from time t53 to time t60, the first output unit 100 is in the dummy data output state 621. During this period, the first output unit 100 outputs a dummy signal to the first signal processing chip 1010. For example, upon input of data for image recording to the first output unit 100, the first output unit 100 transitions from the dummy data output state 621 to the valid data output state 622.

Next, during the period from time t54 to time t60, the second output unit 109 is in the dummy data output state 621. During this period, the second output unit 109 outputs a dummy signal to the second signal processing chip 1011. For example, upon input of data for LV to the second output unit 109, the second output unit 109 transitions from the dummy data output state 621 to the valid data output state 622.

Next, during the period from time t60 to time t61, the first output unit 100 is in the valid data output state 622. During this period, the first output unit 100 outputs data for image recording to the first signal processing chip 1010. For example, upon completion of output of data for image recording from the first output unit 100 to the first signal processing chip 1010, the first output unit 100 transitions from the valid data output state 622 to the dummy data output state 621.

Next, during the period from time t60 to time t62, the second output unit 109 is in the valid data output state 622. During this period, the second output unit 109 outputs data for LV to the second signal processing chip 1011. For example, upon completion of output of data for LV from the second output unit 109 to the second signal processing chip 1011, the second output unit 109 transitions from the valid data output state 622 to the dummy data output state 621.

Next, during the period from time t61 to time t63, the first output unit 100 is in the dummy data output state 621. During this period, the first output unit 100 outputs a dummy signal to the second signal processing chip 1011.

Next, during the period from time t62 to time t63, the second output unit 109 is in the dummy data output state 621. During this period, the second output unit 109 outputs a dummy signal to the second signal processing chip 1011.

Thereafter, at time t63, the first output unit 100 and the second output unit 109 transition from the operation state 611 to the power-saving state 610. At time t63, the first output unit 100 and the second output unit 109 are not required to simultaneously transition from the operation state 611 to the power-saving state 610.

In a case where the first output unit 100 transitions from the operation state 611 to the power-saving state 610 while the second output unit 109 is in the valid data output state 622, noise caused by a power fluctuation may occur. Accordingly, it is desirable that the second output unit 109 not be in the valid data output state 622 during the transition of the first output unit 100 from the operation state 611 to the power-saving state 610. In a case where the second output unit 109 transitions from the operation state 611 to the power-saving state 610 while the first output unit 100 is in the valid data output state 622, noise caused by a power fluctuation may occur. Accordingly, it is desirable that the first output unit 100 not be in the valid data output state 622 during the transition of the second output unit 109 from the operation state 611 to the power-saving state 610.

In the present embodiment, it is possible to perform the moving image capturing mode, which is different from the still image capturing mode, in addition to the still image capturing mode, thereby realizing a variety of image capturing modes.

### Third Embodiment

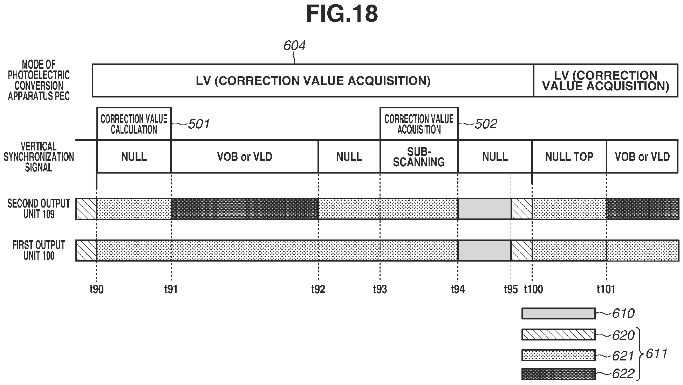

A photoelectric conversion apparatus according to a third embodiment of the present disclosure will be described with reference to Fig. 18. Note that components similar to those in the first or second embodiment are denoted by the same reference numerals, and descriptions of these components may be omitted or simplified.

Fig. 18 illustrates an example of a timing chart of the photoelectric conversion apparatus PEC. Fig. 18 illustrates a timing chart for a case where a fifth mode 604 is repeated during an image capturing mode in which a correction value used for data for image recording is acquired. Data for image recording may be for a still image or for a moving image.

The fifth mode 604 is a mode during which the photoelectric conversion apparatus PEC outputs data for LV and acquires a correction value. During the fifth mode 604, the first output unit 100 and the second output unit 109 are in the operation state 611. The first output unit 100 and the second output unit 109 may be in the operation state 611 even before the fifth mode 604 starts. During the fifth mode 604, the first output unit 100 and the second output unit 109 may transition from the operation state 611 to the power-saving state 610.

Fig. 18 illustrates a case where the fifth mode 604 occurs during the period up to and including time t90 and is maintained at time t90. During the period before time t90, the first output unit 100 and the second output unit 109 transition from the power-saving state 610 to the operation state 611.

During the period before time t90, the first output unit 100 is in the calibration state 620. A calibration period of a predetermined time is required for the first output unit 100 to connect to the first signal processing chip 1010. Accordingly, the calibration period before time t90 is set to equal or exceed the predetermined time.

During the period before time t90, the second output unit 109 is in the calibration state 620. A calibration period of a predetermined time is required for the second output unit 109 to connect to the second signal processing chip 1011. Accordingly, the calibration period before time t90 is set to equal or exceed the predetermined time.

Since the calibration period required for the first output unit 100 is different from the calibration period required for the second output unit 109, the length of the calibration period before time t90 differs. At least a part of the period of the calibration state 620 of the first output unit 100 may overlap with at least a part of the period of the calibration state 620 of the second output unit 109. The overlap allows the first output unit 100 and the second output unit 109 to perform calibration under the same condition.

Next, during the period from time t90 to time t91, the second output unit 109 is in the dummy data output state 621. During this period, the second output unit 109 outputs a dummy signal to the second signal processing chip 1011. For example, the second output unit 109 transitions from the dummy data output state 621 to the valid data output state 622 upon input of data for LV to the second output unit 109. During the period from time t90 to time t91, a correction value calculation 501 is performed. In the correction value calculation 501, a correction value used for data for image recording is calculated using the correction value acquired during the period before time t90.

Next, during the period from time t91 to time t92, the second output unit 109 is in the valid data output state 622. During this period, the second output unit 109 outputs data for LV to the second signal processing chip 1011. For example, upon completion of output of data for LV from the second output unit 109 to the second signal processing chip 1011, the second output unit 109 transitions from the valid data output state 622 to the dummy data output state 621.

Next, during the period from time t92 to time t94, the second output unit 109 is in the dummy data output state 621. During this period, the second output unit 109 outputs a dummy signal to the second signal processing chip 1011. During the period from time t93 to time t94, a correction value acquisition 502 is performed. In the correction value acquisition 502, the correction value used for data for image recording is acquired using the data for LV input to the second output unit 109.

During the period from time t90 to time t94, the first output unit 100 is in the dummy data output state 621. During this period, the first output unit 100 outputs a dummy signal to the first signal processing chip 1010. In order to accurately acquire a correction value used for data for image recording, correction value acquisition can be performed in a state close to the operation state in which the photoelectric conversion apparatus PEC outputs data for image recording. Accordingly, the first output unit 100 is not in the power-saving state 610 but in the operation state 611 during the period from time t93 to time t94 during which the correction value acquisition 502 is performed, thereby making it possible to acquire a highly-accurate correction value.

Thereafter, at time t94, the first output unit 100 and the second output unit 109 transition from the operation state 611 to the power-saving state 610. At time t94, the first output unit 100 and the second output unit 109 are not required to simultaneously transition from the operation state 611 to the power-saving state 610.

In a case where the first output unit 100 transitions from the operation state 611 to the power-saving state 610 while the second output unit 109 is in the valid data output state 622, noise caused by a power fluctuation may occur. Accordingly, it is desirable that the second output unit 109 not be in the valid data output state 622 during the transition of the first output unit 100 from the operation state 611 to the power-saving state 610. In a case where the second output unit 109 transitions from the operation state 611 to the power-saving state 610 while the first output unit 100 is in the valid data output state 622, noise caused by a power fluctuation may occur. Accordingly, it is desirable that the first output unit 100 not be in the valid data output state 622 during the transition of the second output unit 109 from the operation state 611 to the power-saving state 610.

In the present embodiment, it is possible to perform an image capturing mode different from the still image capturing mode in the first embodiment or the moving image capturing mode in the second embodiment, in addition to these modes, thereby realizing a variety of image capturing modes.

### Fourth Embodiment

A fourth embodiment is applicable to any of the first to third embodiments. An embodiment of a photoelectric conversion system using the photoelectric conversion apparatus PEC according to the first embodiment will be described.

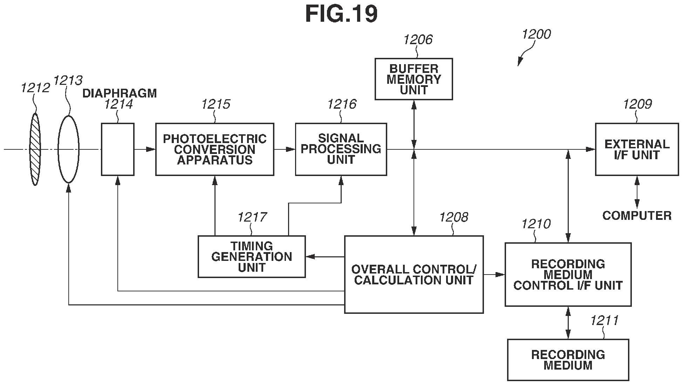

Fig. 19 is a block diagram illustrating a configuration of a photoelectric conversion system 1200 according to the present embodiment. The photoelectric conversion system 1200 according to the present embodiment includes a photoelectric conversion apparatus 1215. The photoelectric conversion apparatus 1215 herein may be the photoelectric conversion apparatus PEC described in the first embodiment. The photoelectric conversion system 1200 may, for example, be used as an image capturing system. Specific examples of the image capturing system include a digital still camera, a digital camcorder, a surveillance camera, and the like. Fig. 19 illustrates an example of a digital still camera as the photoelectric conversion system 1200.

The photoelectric conversion system 1200 illustrated in Fig. 19 includes the photoelectric conversion apparatus 1215, a lens 1213, a diaphragm 1214, and a barrier 1212. The lens 1213 forms an optical image of a subject on the photoelectric conversion apparatus 1215. The diaphragm 1214 controls an amount of light passing through the lens 1213. The barrier 1212 protects the lens 1213.

The lens 1213 and the diaphragm 1214 form an optical system configured to focus light onto the photoelectric conversion apparatus 1215.

The photoelectric conversion system 1200 includes a signal processing unit 1216 configured to process an output signal output from the photoelectric conversion apparatus 1215. The signal processing unit 1216 performs a signal processing operation to perform various types of correction and compression on an input signal, as necessary, and output the resulting signal. The signal processing unit 1216 includes the first signal processing chip 1010 and the second signal processing chip 1011 illustrated in Fig. 15. The photoelectric conversion system 1200 further includes a buffer memory unit 1206 and an external interface unit (external I/F unit) 1209. The buffer memory unit 1206 is configured to temporarily store image data, and the external I/F unit 1209 is configured to communicate with an external computer and the like. The photoelectric conversion system 1200 further includes a recording medium 1211 for recording or reading captured data, such as a semiconductor memory, and a recording medium control interface unit (recording medium control I/F unit) 1210 for recording data to or reading data from the recording medium 1211. The recording medium 1211 may be built into the photoelectric conversion system 1200 or may be removable. Further, the recording medium control I/F unit 1210 may communicate with the recording medium 1211 wirelessly, and communication from the external I/F unit 1209 may be wireless.

The photoelectric conversion system 1200 further includes an overall control/calculation unit 1208 and a timing generation unit 1217. The overall control/calculation unit 1208 is configured to perform various calculations and control the entire digital still camera. The timing generation unit 1217 is configured to output various timing signals to the photoelectric conversion apparatus 1215 and the signal processing unit 1216. The timing signals and the like may be input from an external source, and it is sufficient for the photoelectric conversion system 1200 to include at least the photoelectric conversion apparatus 1215 and the signal processing unit 1216 configured to process an output signal output from the photoelectric conversion apparatus 1215. As described above in the fourth embodiment, the timing generation unit 1217 may be mounted on the photoelectric conversion apparatus 1215. The overall control/calculation unit 1208 and the timing generation unit 1217 may be configured to perform some or all of the control functions of the photoelectric conversion apparatus 1215.

The photoelectric conversion apparatus 1215 outputs an image signal to the signal processing unit 1216. The signal processing unit 1216 performs predetermined signal processing on the image signal output from the photoelectric conversion apparatus 1215 and outputs image data. Further, the signal processing unit 1216 generates an image using the image signal. Further, the signal processing unit 1216 may perform a distance calculation on a signal output from the photoelectric conversion apparatus 1215. The signal processing unit 1216 and the timing generation unit 1217 may be mounted on the photoelectric conversion apparatus 1215. In other words, the signal processing unit 1216 and the timing generation unit 1217 may be provided on the substrate on which pixels are arranged, or may be provided on another substrate. By configuring an image capturing system using the photoelectric conversion apparatus according to any of the above-described embodiments, an image capturing system capable of acquiring a higher-quality image is realized.

### Fifth Embodiment

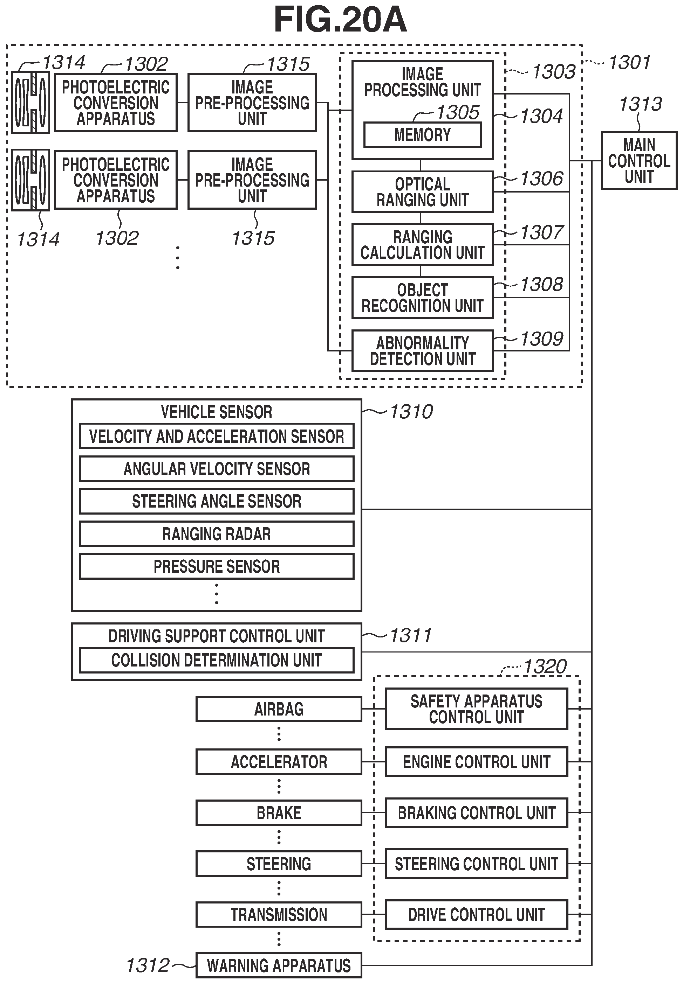

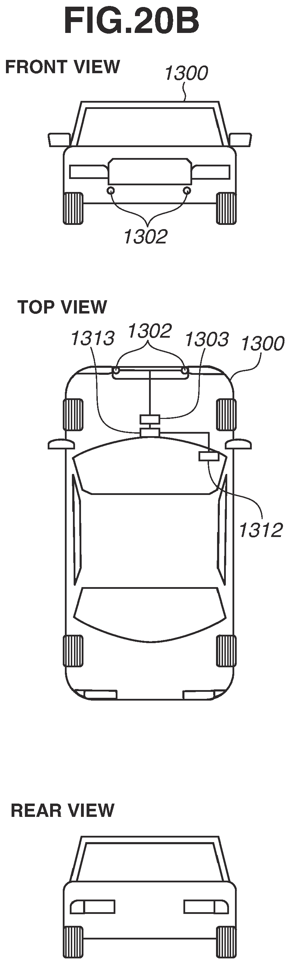

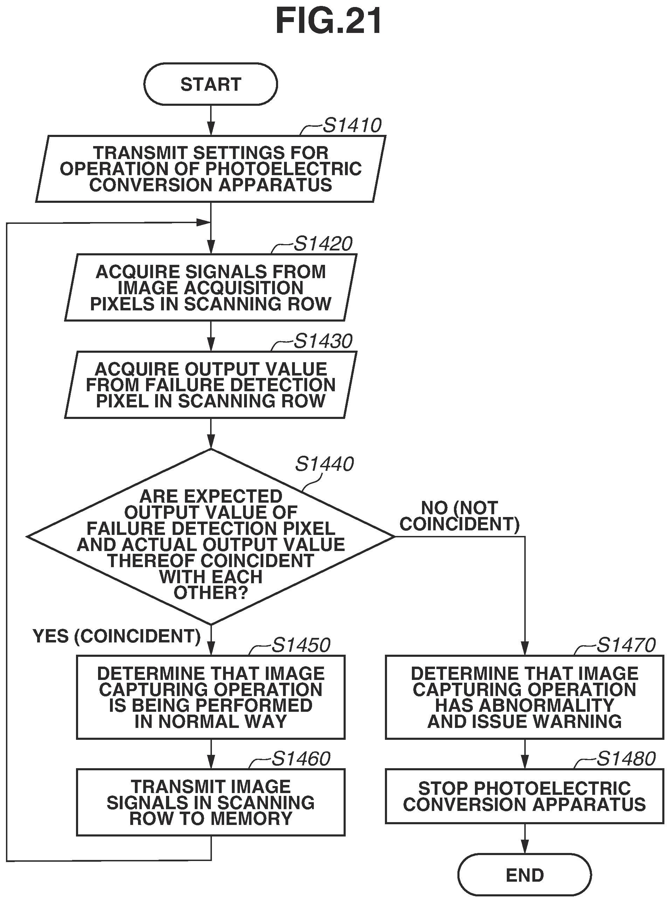

A fifth embodiment is applicable to any of the first to third embodiments. A photoelectric conversion system and a moving object (e.g., a vehicle or a vehicle system comprising a vehicle) according to the present embodiment will be described with reference to Figs. 20A, 20B, and 21. Figs. 20A and 20B are schematic diagrams illustrating examples of configurations of a photoelectric conversion system and a moving object according to the present embodiment. Fig. 21 is a flowchart illustrating an operation of the photoelectric conversion system according to the present embodiment. In the present embodiment, an example of an in-vehicle camera is described as the photoelectric conversion system.

Figs. 20A and 20B illustrate an example of a vehicle system and a photoelectric conversion system mounted on the vehicle system and configured to capture an image. A photoelectric conversion system 1301 includes a photoelectric conversion apparatus 1302, an image pre-processing unit 1315, an integrated circuit 1303, and an optical system 1314. The optical system 1314 forms an optical image of a subject on the photoelectric conversion apparatus 1302. The photoelectric conversion apparatus 1302 converts an optical image of a subject formed by the optical system 1314 into an electrical signal. The photoelectric conversion apparatus 1302 corresponds to a photoelectric conversion apparatus according to any of the above-described embodiments. The image pre-processing unit 1315 performs predetermined signal processing on a signal output from the photoelectric conversion apparatus 1302. The function of the image pre-processing unit 1315 may be implemented within the photoelectric conversion apparatus 1302. The photoelectric conversion system 1301 includes at least two sets of optical systems 1314, two sets of photoelectric conversion apparatuses 1302, and two sets of image pre-processing units 1315, and an output from the image pre-processing units 1315 of each set is input to the integrated circuit 1303.

The integrated circuit 1303 is an integrated circuit for an image capturing system and includes an image processing unit 1304, an optical ranging unit 1306, a ranging calculation unit 1307, an object recognition unit 1308, and an abnormality detection unit 1309. The image processing unit 1304 includes a memory 1305. The image processing unit 1304 performs image processing, such as development processing and defect correction, on an output signal from the image pre-processing unit 1315. The memory 1305 temporarily stores a captured image and stores a position of a defective pixel. The optical ranging unit 1306 performs subject focusing and distance measurement. The ranging calculation unit 1307 calculates distance measurement information based on a plurality of pieces of image data acquired from the plurality of photoelectric conversion apparatuses 1302. The object recognition unit 1308 recognizes a subject, such as a vehicle, road, sign, or person. In a case where an abnormality is detected in the photoelectric conversion apparatus 1302, the abnormality detection unit 1309 notifies a main control unit 1313 of the abnormality.

The integrated circuit 1303 may be realized by dedicated hardware, a software module, or a combination thereof. Further, the integrated circuit 1303 may be realized by a field programmable gate array (FPGA), an application specific integrated circuit (ASIC), or the like, or a combination thereof.

The main control unit 1313 collectively controls the operation of the photoelectric conversion system 1301, a vehicle sensor 1310, a control unit 1320, and the like. It is also possible to employ a method in which the main control unit 1313 is not included and each of the photoelectric conversion system 1301, the vehicle sensor 1310, and the control unit 1320 includes a communication interface to transmit and receive a control signal via a communication network (e.g., Controller Area Network (CAN) standard).

The integrated circuit 1303 includes a function that transmits a control signal or a setting value to the photoelectric conversion apparatus 1302 in response to a control signal received from the main control unit 1313 or through a control unit of the integrated circuit 1303.

The photoelectric conversion system 1301 is connected to the vehicle sensor 1310 and configured to detect a driving state of the vehicle, such as a vehicle speed, yaw rate, and steering angle, an environment outside the vehicle, a state of another vehicle, and a state of an obstacle. The vehicle sensor 1310 is also a distance information acquisition unit configured to acquire distance information to a target object. Further, the photoelectric conversion system 1301 is connected to a driving support control unit 1311 configured to perform various driving support functions, such as automatic steering, automatic cruise control, and collision prevention. In particular, regarding a collision determination function, estimation of a collision with another vehicle or an obstacle and determination of the presence or absence of a collision are performed based on detection results from the photoelectric conversion system 1301 and the vehicle sensor 1310. As a result, avoidance control is performed in a case where a collision is estimated, and a safety apparatus is activated upon collision.

Further, the photoelectric conversion system 1301 is also connected to a warning apparatus 1312 configured to provide a warning to a driver based on a determination result of a collision determination unit. For example, in a case where the determination result of the collision determination unit indicates a high likelihood of a collision, the main control unit 1313 controls the vehicle to avoid a collision and reduce damage by applying a brake, releasing an accelerator, or suppressing engine output. The warning apparatus 1312 provides a warning to a user by providing an audible warning, such as a sound, displaying warning information on a display screen of a display unit, such as a car navigation system or an instrument panel, and/or vibrating a seat belt or a steering wheel.

In the fifth embodiment, the photoelectric conversion system 1301 is used to perform image capturing of the surroundings of a vehicle, for example, the forward or backward scene thereof. Fig. 20B illustrates an example of location of the photoelectric conversion system 1301 employed in a case where the photoelectric conversion system 1301 performs image capturing of the forward scene of a vehicle.

Two photoelectric conversion apparatuses 1302 are located at the front portion of a vehicle 1300. Specifically, a center line with respect to a forward or backward movement orientation or an outer shape (for example, vehicle width) of the vehicle 1300 is regarded as a symmetrical axis, and two photoelectric conversion apparatuses 1302 are located in line symmetry with respect to the symmetrical axis. This configuration is favorable in performing acquisition of distance information about a distance between the vehicle 1300 and a subject target and determination of the collision probability therebetween.

Moreover, it is favorable that the photoelectric conversion apparatuses 1302 are located at positions which do not hinder the field of view of a driver when the driver visually recognizes a situation outside the vehicle 1300 from the driver's seat. It is favorable that the warning apparatus 1312 is located at a position which is likely to come within the field of view of the driver.

Next, a failure detection operation of the photoelectric conversion apparatus 1302 in the photoelectric conversion system 1301 is described with reference to Fig. 21. The failure detection operation of the photoelectric conversion apparatus 1302 is performed according to steps S1410 to S1480 illustrated in Fig. 21.

Step S1410 is a step of performing setting at the time of start-up of the photoelectric conversion apparatus 1302. More specifically, the photoelectric conversion system 1301 transmits settings for an operation of the photoelectric conversion apparatus 1302 from an external source of the photoelectric conversion system 1301 (for example, the main control unit 1313) or from the inside of the photoelectric conversion system 1301, and starts an image capturing operation and a failure detection operation of the photoelectric conversion apparatus 1302.

Next, in step S1420, the photoelectric conversion system 1301 acquires pixel signals from effective pixels. Moreover, in step S1430, the photoelectric conversion system 1301 acquires an output value from a failure detection pixel provided for failure detection. The failure detection pixel is also provided with a photoelectric conversion portion as with the effective pixels. A predetermined voltage is written into the photoelectric conversion portion. The failure detection pixel outputs a signal corresponding to the voltage written in the photoelectric conversion portion. Furthermore, step S1420 and step S1430 can be transposed.

Next, in step S1440, the photoelectric conversion system 1301 determines whether the expected output value of the failure detection pixel and the actual output value of the failure detection pixel are coincident with each other.

If, as a result of determination of coincidence in step S1440, it is determined that the expected output value and the actual output value are coincident with each other (YES in step S1440), the processing proceeds to step S1450, in which the photoelectric conversion system 1301 determines that the image capturing operation is being performed in a normal way, and, then, the processing proceeds to step S1460. In step S1460, the photoelectric conversion system 1301 transmits pixel signals in the scanning row to the memory 1305 and temporarily stores the pixel signals therein. After that, the processing returns to step S1420, in which the photoelectric conversion system 1301 continues the failure detection operation.

On the other hand, if, as a result of determination of coincidence in step S1440, it is determined that the expected output value and the actual output value are not coincident with each other (NO in step S1440), the processing proceeds to step S1470. In step S1470, the photoelectric conversion system 1301 determines that the image capturing operation has an abnormality and then issues a warning to the main control unit 1313 or the warning apparatus 1312. The warning apparatus 1312 causes the display unit to display detection of the abnormality. After that, in step S1480, the photoelectric conversion system 1301 stops the photoelectric conversion apparatus 1302, thus ending the failure detection operation.

Furthermore, while, in the fifth embodiment, an example in which the flowchart is looped in every row has been described, the flowchart can be looped in every plurality of rows, or the failure detection operation can be performed in every frame.

Furthermore, the issuance of a warning in step S1470 can be configured to be communicated to the outside of the vehicle via a wireless network.

Moreover, while, in the fifth embodiment, a control operation for preventing collision with another vehicle has been described, the fifth embodiment can also be applied to a control operation for performing autonomous driving while tracking another vehicle or a control operation for performing autonomous driving in such a way as not to run off the lane. Additionally, the photoelectric conversion system 1301 can be applied to not only a vehicle such as a car but also, for example, a moving body (moving apparatus) such as a boat or ship, an airplane, or an industrial robot. Additionally, the photoelectric conversion system 1301 can be applied to not only a moving body but also various apparatuses which use object recognition, such as an intelligent transportation system (ITS).

The disclosure is not limited to the above embodiments, and various changes and modifications can be made without departing from the spirit and scope of the disclosure. Accordingly, the claims are appended in order to make public the scope of the disclosure.

In the present specification, expressions such as "A or B," "at least one of A and B," "at least one of A or/and B," and "one or more of A or/and B" include all possible combinations of the listed items, unless otherwise explicitly defined. More specifically, the above expressions are understood to disclose all of the following cases: a case including at least one A, a case including at least one B, and a case including both at least one A and at least one B. This applies similarly to combinations of three or more elements.

The embodiments described above can be modified as appropriate without departing from the technical idea. The disclosure of the present specification includes not only what is described in the present specification but also all matters that can be understood from the present specification and the drawings attached to the present specification. The disclosure of the present specification also includes a complement set of the concepts described in the present specification. More specifically, if, for example, the present specification describes that "A is larger than B," even if a description that "A is not larger than B" is omitted, it can be said that the present specification discloses that "A is not larger than B." This is because, when describing that "A is larger than B," it is premised that a case where "A is not larger than B" is taken into consideration.

The disclosure of the present embodiment includes the following configurations.
1. A photoelectric conversion apparatus comprising: a pixel, a first output circuit configured to output a first signal having an amplitude value selected from a first number of amplitude values based on a signal output from the pixel, the first number being two or more, a second output circuit configured to output a second signal having an amplitude value selected from a second number of amplitude values based on a signal output from the pixel, the second number being different from the first number, and a control circuit configured to control the first output circuit and the second output circuit, wherein the control circuit controls the first output circuit and the second output circuit to a first mode, and wherein, in the first mode, the first output circuit is in a power-saving state during a period in which the second output circuit is in an operation state.
2. The photoelectric conversion apparatus according to configuration 1, wherein the first output circuit has lower power consumption in the power-saving state than in the operation state.
3. The photoelectric conversion apparatus according to configuration 1 or 2, wherein, during the period in which the second output circuit is in the operation state, the second output circuit outputs the second signal, and during a period in which the first output circuit is in the power-saving state, the first output circuit does not output the first signal.
4. The photoelectric conversion apparatus according to any one of configurations 1 to 3, wherein the first output circuit outputs a third signal having an amplitude value selected from the first number of amplitude values based on a signal having a single fixed value, wherein the first output circuit outputs a fifth signal having an amplitude value selected from the first number of amplitude values based on a signal having a plurality of fixed values, wherein the second output circuit outputs a fourth signal having an amplitude value selected from the second number of amplitude values based on a signal having a single fixed value, wherein the second output circuit outputs a sixth signal having an amplitude value selected from the second number of amplitude values based on a signal having a plurality of fixed values, wherein the second output circuit outputs the second signal, the fourth signal, and the sixth signal during the period in which the second output circuit is in the operation state, and wherein the first output circuit does not output the first signal, the third signal, or the fifth signal during a period in which the first output circuit is in the power-saving state.
5. The photoelectric conversion apparatus according to any one of configurations 1 to 4, wherein, during the period in which the second output circuit is in the operation state, the second output circuit outputs the sixth signal, the fourth signal, and the second signal in this order.
6. The photoelectric conversion apparatus according to any one of configurations 1 to 5, further comprising a first conversion circuit configured to perform a first conversion operation to convert a parallel signal output from the first output circuit into a serial signal, wherein during a period in which the first output circuit is in the power-saving state, the first conversion circuit does not perform the first conversion operation.
7. The photoelectric conversion apparatus according to any one of configurations 1 to 6, further comprising a first adjustment circuit configured to perform a first adjustment operation to adjust an amount of a signal input to the first output circuit, wherein, during a period in which the first output circuit is in the power-saving state, the first adjustment circuit does not perform the first adjustment operation.
8. The photoelectric conversion apparatus according to any one of configurations 1 to 7, further comprising a first processing circuit configured to perform a first processing operation including at least one of dithering processing and compression processing on a signal input to the first output circuit, wherein, during a period in which the first output circuit is in the power-saving state, the first processing circuit does not perform the first processing operation.
9. The photoelectric conversion apparatus according to any one of configurations 1 to 8, wherein the control circuit controls the first output circuit and the second output circuit to a second mode, and wherein, in the second mode, at least a part of the period in which the second output circuit is in the operation state overlaps with at least a part of a period in which the first output circuit is in the operation state.
10. The photoelectric conversion apparatus according to any one of configurations 1 to 9, wherein, in the second mode, the second output circuit outputs the second signal during the period in which the second output circuit is in the operation state, the first output circuit outputs the first signal during the period in which the first output circuit is in the operation state, and at least a part of the period in which the second output circuit outputs the second signal overlaps with at least a part of the period in which the first output circuit outputs the first signal.
11. The photoelectric conversion apparatus according to any one of configurations 1 to 10, wherein, in the second mode, the second output circuit outputs the second signal during the period in which the second output circuit is in the operation state, and the first output circuit is in the operation state during a period in which the second output circuit outputs the second signal.
12. The photoelectric conversion apparatus according to any one of configurations 1 to 11, wherein the first output circuit outputs a third signal having an amplitude value selected from the first number of amplitude values based on a signal having a single fixed value, wherein the first output circuit outputs a fifth signal having an amplitude value selected from the first number of amplitude values based on a signal having a plurality of fixed values, wherein the second output circuit outputs a fourth signal having an amplitude value selected from the second number of amplitude values based on a signal having a single fixed value, wherein the second output circuit outputs a sixth signal having an amplitude value selected from the second number of amplitude values based on a signal having a plurality of fixed values, wherein, in the second mode, the second output circuit outputs the second signal, the fourth signal, and the sixth signal during the period in which the second output circuit is in the operation state, and wherein, in the second mode, the first output circuit outputs the first signal, the third signal, and the fifth signal during the period in which the first output circuit is in the operation state.
13. The photoelectric conversion apparatus according to any one of configurations 1 to 12, wherein, in the second mode, the second output circuit outputs the sixth signal, the fourth signal, the second signal, and the fourth signal in this order during the period in which the second output circuit is in the operation state, and the first output circuit outputs the fifth signal, the third signal, the first signal, and the third signal in this order during the period in which the first output circuit is in the operation state.
14. The photoelectric conversion apparatus according to any one of configurations 1 to 13, wherein, in the second mode, at least a part of a period in which the second output circuit outputs the sixth signal overlaps with at least a part of a period in which the first output circuit outputs the fifth signal.
15. The photoelectric conversion apparatus according to any one of configurations 1 to 14, wherein the control circuit controls the first output circuit and the second output circuit to a third mode including a correction value acquisition period, and wherein the first output circuit and the second output circuit are in the operation state during the correction value acquisition period in the third mode.
16. The photoelectric conversion apparatus according to any one of configurations 1 to 15, wherein the first signal has an amplitude value selected from three or more amplitude values, and the second signal has an amplitude value selected from two amplitude values.
17. A photoelectric conversion system comprising: the photoelectric conversion apparatus according to any one of configurations 1 to 16, a first signal processing circuit connected to the first output circuit, and a second signal processing circuit connected to the second output circuit.
18. The photoelectric conversion system according to configuration 17, wherein the first signal processing circuit generates an image for recording using the first signal, and the second signal processing circuit performs focus detection using the second signal.
19. A moving object comprising: the photoelectric conversion apparatus according to any one of configurations 1 to 16, and distance information acquisition means for acquiring distance information to a target object using distance measurement information based on a signal from the photoelectric conversion apparatus, wherein the moving object further includes control means for controlling the moving object based on the distance information.
20. A control method for a photoelectric conversion apparatus comprising a pixel (10), a first output circuit (100), a second output circuit (109), and a control circuit (120) configured to control the first output circuit (100) and the second output circuit (109), the control method comprising:
   outputting, by the first output circuit (100), a first signal having an amplitude value selected from a first number of amplitude values based on a signal output from the pixel (10), the first number being two or more;
   outputting, by the second output circuit (109), a second signal having an amplitude value selected from a second number of amplitude values based on a signal output from the pixel (10), the second number being different from the first number; and
   controlling, by the control circuit (120), the first output circuit (100) and the second output circuit (109) to be in a first mode,
   wherein, in the first mode, the first output circuit (100) is in a power-saving state during a period in which the second output circuit (109) is in an operation state.

The control method described above in Configuration 20 may be combined with one or more steps carried out by the apparatuses described in Configurations 1 to 19, or with one or more other steps carried out by apparatuses in other aspects of this disclosure. A computer program may be provided comprising instructions which when executed by a computer, cause the computer to carry out the control method described above. A non-transitory computer readable storage medium may comprise instructions which when executed by a computer, cause the computer to carry out the control method described above.

The present disclosure makes it possible to provide a photoelectric conversion apparatus configured to reduce power consumption.

Various embodiments have been described in detail above but it will be understood that the present disclosure is not limited to these embodiments and encompasses all modifications, variants, alternatives and equivalents falling within the scope of the appended claims.

## Claims

1. A photoelectric conversion apparatus (1215, 1302) comprising:
a pixel (10);
a first output circuit (100) configured to output a first signal having an amplitude value selected from a first number of amplitude values based on a signal output from the pixel (10), the first number being two or more;
a second output circuit (109) configured to output a second signal having an amplitude value selected from a second number of amplitude values based on a signal output from the pixel (10), the second number being different from the first number; and
a control circuit (120) configured to control the first output circuit (100) and the second output circuit (109),
wherein the control circuit (120) is configured to control the first output circuit (100) and the second output circuit (109) to be in a first mode, and
wherein, in the first mode, the first output circuit (100) is in a power-saving state during a period in which the second output circuit (109) is in an operation state.

2. The photoelectric conversion apparatus (1215, 1302) according to claim 1, wherein the first output circuit (100) has lower power consumption in the power-saving state than in an operation state of the first output circuit (100).

3. The photoelectric conversion apparatus according to claim 1 or 2, configured such that, during the period in which the second output circuit (109) is in the operation state, the second output circuit (109) outputs the second signal, and during a period in which the first output circuit (100) is in the power-saving state, the first output circuit (100) does not output the first signal.

4. The photoelectric conversion apparatus (1215, 1302) according to any one of claims 1 to 3,
wherein the first output circuit (100) is configured to output a third signal having an amplitude value selected from the first number of amplitude values based on a signal having a single fixed value,
wherein the first output circuit (100) is configured to output a fifth signal having an amplitude value selected from the first number of amplitude values based on a signal having a plurality of fixed values,
wherein the second output circuit (109) is configured to output a fourth signal having an amplitude value selected from the second number of amplitude values based on a signal having a single fixed value,
wherein the second output circuit (109) is configured to output a sixth signal having an amplitude value selected from the second number of amplitude values based on a signal having a plurality of fixed values,
wherein the second output circuit (109) is configured to output the second signal, the fourth signal, and the sixth signal during the period in which the second output circuit (109) is in the operation state, and
wherein the first output circuit (100) is configured not to output the first signal, the third signal, or the fifth signal during a period in which the first output circuit (100) is in the power-saving state.

5. The photoelectric conversion apparatus (1215, 1302) according to claim 4, configured such that, during the period in which the second output circuit (109) is in the operation state, the second output circuit (109) outputs the sixth signal, the fourth signal, and the second signal in this order.

6. The photoelectric conversion apparatus (1215, 1302) according to any one of claims 1 to 5, further comprising a first conversion circuit (200) configured to perform a first conversion operation to convert a parallel signal output from the first output circuit (100) into a serial signal, and configured such that, during a period in which the first output circuit (100) is in the power-saving state, the first conversion circuit (200) does not perform the first conversion operation.

7. The photoelectric conversion apparatus (1215, 1302) according to any one of claims 1 to 6, further comprising a first adjustment circuit (1087) configured to perform a first adjustment operation to adjust an amount of a signal input to the first output circuit (100), and configured such that, during a period in which the first output circuit (100) is in the power-saving state, the first adjustment circuit (1087) does not perform the first adjustment operation.

8. The photoelectric conversion apparatus (1215, 1302) according to any one of claims 1 to 7, further comprising a first processing circuit (1085) configured to perform a first processing operation including at least one of dithering processing and compression processing on a signal input to the first output circuit (100), and configured such that, during a period in which the first output circuit (100) is in the power-saving state, the first processing circuit (1085) does not perform the first processing operation.

9. The photoelectric conversion apparatus (1215, 1302) according to any one of claims 1 to 8,
wherein the control circuit (120) is configured to control the first output circuit (100) and the second output circuit (109) in a second mode, and
wherein, in the second mode, at least a part of the period in which the second output circuit (109) is in the operation state overlaps with at least a part of a period in which the first output circuit (100) is in the operation state.

10. The photoelectric conversion apparatus (1215, 1302) according to claim 9, configured such that, in the second mode, the second output circuit (109) outputs the second signal during the period in which the second output circuit (109) is in the operation state, the first output circuit (100) outputs the first signal during the period in which the first output circuit (100) is in the operation state, and at least a part of the period in which the second output circuit (109) outputs the second signal overlaps with at least a part of the period in which the first output circuit (100) outputs the first signal.

11. The photoelectric conversion apparatus (1215, 1302) according to claim 9, wherein, in the second mode, the second output circuit (109) is configured to output the second signal during the period in which the second output circuit (109) is in the operation state, and the first output circuit (100) is configured to be in the operation state during a period in which the second output circuit (109) outputs the second signal.

12. A photoelectric conversion system (1200, 1301) comprising:
the photoelectric conversion apparatus (1215, 1302) according to any one of claims 1 to 12;
a first signal processing circuit (1010) connected to the first output circuit (100); and
a second signal processing circuit (1011) connected to the second output circuit (109).

13. The photoelectric conversion system (1200, 1301) according to claim 12, wherein the first signal processing circuit (1010) is configured to generate an image for recording using the first signal, and the second signal processing circuit (1011) is configured to perform focus detection using the second signal.

14. A moving object comprising:
the photoelectric conversion apparatus (1215, 1302) according to any one of claims 1 to 11; and
distance information acquisition means (1310) for acquiring distance information to a target object using distance measurement information based on a signal from the photoelectric conversion apparatus (1215, 1302),
wherein the moving object further includes control means (1313) for controlling the moving object based on the distance information.

15. A control method for a photoelectric conversion apparatus comprising a pixel (10), a first output circuit (100), a second output circuit (109), and a control circuit (120) configured to control the first output circuit (100) and the second output circuit (109), the control method comprising:
outputting, by the first output circuit (100), a first signal having an amplitude value selected from a first number of amplitude values based on a signal output from the pixel (10), the first number being two or more;
outputting, by the second output circuit (109), a second signal having an amplitude value selected from a second number of amplitude values based on a signal output from the pixel (10), the second number being different from the first number; and
controlling, by the control circuit (120), the first output circuit (100) and the second output circuit (109) to be in a first mode,
wherein, in the first mode, the first output circuit (100) is in a power-saving state during a period in which the second output circuit (109) is in an operation state.
